# EUROPEAN PATENT APPLICATION

(11) **EP 4 567 892 A1**
(43) Date of publication of application: **11.06.2025**
(21) Application number: 23849963.6
(22) Date of filing: 25.07.2023
(51) Int. Cl.: H01L 27/146

(54) **IMAGING DEVICE**

(30) Priority: 03.08.2022 JP 2022123953
(71) Applicant: Sony Semiconductor Solutions Corporation, Atsugi-shi, Kanagawa 243-0014 (JP)
(72) Inventor: OSHIYAMA, Itaru, Atsugi-shi, Kanagawa 243-0014 (JP); MARUYAMA, Toru, Atsugi-shi, Kanagawa 243-0014 (JP); MIYANAMI, Yuki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/027249
(87) International publication number: WO 2024/029408

(57) **Abstract**

An imaging device according to an embodiment of the present disclosure includes a plurality of pixels including a photoelectric conversion unit that photoelectrically converts light, a color filter provided for each pixel, a separation unit provided between the adjacent photoelectric conversion units, a structure having an air gap provided between the adjacent color filters, and a metal compound layer provided on the photoelectric conversion unit between the color filter and the photoelectric conversion unit. The structure is provided from between the adjacent color filters to the metal compound layer and is coupled to the separation unit.

## Description

### Technical Field

The present disclosure relates to an imaging device.

### Background Art

An imaging device in which an air gap with a refractive index lower than that of a color filter is provided between the two adjacent color filters is proposed (PTL 1).

### Citation List

### Patent Literature

PTL 1: U.S. Patent Application Publication No. 2019/0157329

### Summary of the Invention

An imaging device is required to prevent color mixture between pixels.

It is desirable to provide an imaging device that makes it possible to reduce the color mixture.

An imaging device according to an embodiment of the present disclosure includes a plurality of pixels including a photoelectric conversion unit that photoelectrically converts light, a color filter provided for each pixel, a separation unit provided between the adjacent photoelectric conversion units, a structure having an air gap provided between the adjacent color filters, and a metal compound layer provided on the photoelectric conversion unit between the color filter and the photoelectric conversion unit. The structure is provided from between the adjacent color filters to the metal compound layer and is coupled to the separation unit.

### Brief Description of Drawing

[FIG. 1] FIG. 1 is a block diagram illustrating an example of a schematic configuration of an imaging device according to a first embodiment of the present disclosure.
[FIG. 2] FIG. 2 is a diagram illustrating an example of a pixel portion of the imaging device according to the first embodiment of the present disclosure.
[FIG. 3] FIG. 3 is a diagram illustrating an example of a cross-sectional configuration of the imaging device according to the first embodiment of the present disclosure.
[FIG. 4] FIG. 4 is a diagram illustrating an example of a plane configuration of the imaging device according to the first embodiment of the present disclosure.
[FIG. 5] FIG. 5 is a diagram illustrating an example of the cross-sectional configuration of the imaging device according to the first embodiment of the present disclosure.
[FIG. 6A] FIG. 6A is a diagram illustrating a method for manufacturing the imaging device according to the first embodiment of the present disclosure.
[FIG. 6B] FIG. 6B is a diagram illustrating an example of the method for manufacturing the imaging device according to the first embodiment of the present disclosure.
[FIG. 6C] FIG. 6C is a diagram illustrating an example of the method for manufacturing the imaging device according to the first embodiment of the present disclosure.
[FIG. 6D] FIG. 6D is a diagram illustrating an example of the method for manufacturing the imaging device according to the first embodiment of the present disclosure.
[FIG. 7] FIG. 7 is a diagram illustrating an example of the cross-sectional configuration of the imaging device according to a first modification example of the present disclosure.
[FIG. 8A] FIG. 8A is a diagram illustrating an example of a method for manufacturing the imaging device according to the first modification example of the present disclosure.
[FIG. 8B] FIG. 8B is a diagram illustrating an example of the method for manufacturing the imaging device according to the first modification example of the present disclosure.
[FIG. 8C] FIG. 8C is a diagram illustrating an example of the method for manufacturing the imaging device according to the first modification example of the present disclosure.
[FIG. 8D] FIG. 8D is a diagram illustrating an example of the method for manufacturing the imaging device according to the first modification example of the present disclosure.
[FIG. 9] FIG. 9 is a diagram illustrating an example of the cross-sectional configuration of the imaging device according to a second modification example of the present disclosure.
[FIG. 10A] FIG. 10A is a diagram illustrating an example of a method for manufacturing the imaging device according to the second modification example of the present disclosure.
[FIG. 10B] FIG. 10B is a diagram illustrating an example of the method for manufacturing the imaging device according to the second modification example of the present disclosure.
[FIG. 10C] FIG. 10C is a diagram illustrating an example of the method for manufacturing the imaging device according to the second modification example of the present disclosure.
[FIG. 10D] FIG. 10D is a diagram illustrating an example of the method for manufacturing the imaging device according to the second modification example of the present disclosure.
[FIG. 11] FIG. 11 is a diagram illustrating an example of the cross-sectional configuration of the imaging device according to a third modification example of the present disclosure.
[FIG. 12A] FIG. 12A is a diagram illustrating an example of a method for manufacturing the imaging device according to the third modification example of the present disclosure.
[FIG. 12B] FIG. 12B is a diagram illustrating an example of the method for manufacturing the imaging device according to the third modification example of the present disclosure.
[FIG. 12C] FIG. 12C is a diagram illustrating an example of the method for manufacturing the imaging device according to the third modification example of the present disclosure.
[FIG. 12D] FIG. 12D is a diagram illustrating an example of the method for manufacturing the imaging device according to the third modification example of the present disclosure.
[FIG. 13] FIG. 13 is a diagram illustrating an example of the cross-sectional configuration of the imaging device according to a fourth modification example of the present disclosure.
[FIG. 14A] FIG. 14A is a diagram illustrating an example of a method for manufacturing the imaging device according to the fourth modification example of the present disclosure.
[FIG. 14B] FIG. 14B is a diagram illustrating an example of the method for manufacturing the imaging device according to the fourth modification example of the present disclosure.
[FIG. 14C] FIG. 14C is a diagram illustrating an example of the method for manufacturing the imaging device according to the fourth modification example of the present disclosure.
[FIG. 14D] FIG. 14D is a diagram illustrating an example of the method for manufacturing the imaging device according to the fourth modification example of the present disclosure.
[FIG. 15] FIG. 15 is a diagram illustrating an example of a cross-sectional configuration of an imaging device according to a second embodiment of the present disclosure.
[FIG. 16] FIG. 16 is a diagram illustrating an example of the cross-sectional configuration of the imaging device according to the second embodiment of the present disclosure.
[FIG. 17] FIG. 17 is a diagram illustrating another example of the cross-sectional configuration of the imaging device according to the second embodiment of the present disclosure.
[FIG. 18A] FIG. 18A is a diagram illustrating an example of a method for manufacturing the imaging device according to the second embodiment of the present disclosure.
[FIG. 18B] FIG. 18B is a diagram illustrating an example of the method for manufacturing the imaging device according to the second embodiment of the present disclosure.
[FIG. 18C] FIG. 18C is a diagram illustrating an example of the method for manufacturing the imaging device according to the second embodiment of the present disclosure.
[FIG. 18D] FIG. 18D is a diagram illustrating an example of the method for manufacturing the imaging device according to the second embodiment of the present disclosure.
[FIG. 19] FIG. 19 is a diagram illustrating an example of the cross-sectional configuration of the imaging device according to a fifth modification example of the present disclosure.
[FIG. 20A] FIG. 20A is a diagram illustrating an example of a method for manufacturing the imaging device according to the fifth modification example of the present disclosure.
[FIG. 20B] FIG. 20B is a diagram illustrating an example of the method for manufacturing the imaging device according to the fifth modification example of the present disclosure.
[FIG. 20C] FIG. 20C is a diagram illustrating an example of the method for manufacturing the imaging device according to the fifth modification example of the present disclosure.
[FIG. 20D] FIG. 20D is a diagram illustrating an example of the method for manufacturing the imaging device according to the fifth modification example of the present disclosure.
[FIG. 21] FIG. 21 is a diagram illustrating an example of the cross-sectional configuration of the imaging device according to a sixth modification example of the present disclosure.
[FIG. 22] FIG. 22 is a block diagram illustrating a configuration example of an electronic apparatus including the imaging device.
[FIG. 23] FIG. 23 is a block diagram depicting an example of schematic configuration of a vehicle control system.
[FIG. 24] FIG. 24 is a diagram of assistance in explaining an example of installation positions of an outside-vehicle information detecting section and an imaging section.
[FIG. 25] FIG. 25 is a view depicting an example of a schematic configuration of an endoscopic surgery system.
[FIG. 26] FIG. 26 is a block diagram depicting an example of a functional configuration of a camera head and a camera control unit (CCU).

### Modes for Carrying Out the Invention

In the following, embodiments of the present disclosure are described in detail with reference to the drawings. It is to be noted that the description be given in the following order.
1. First Embodiment
2. Second Embodiment
3. Application Example
4. Example of Application

### <1. First Embodiment>

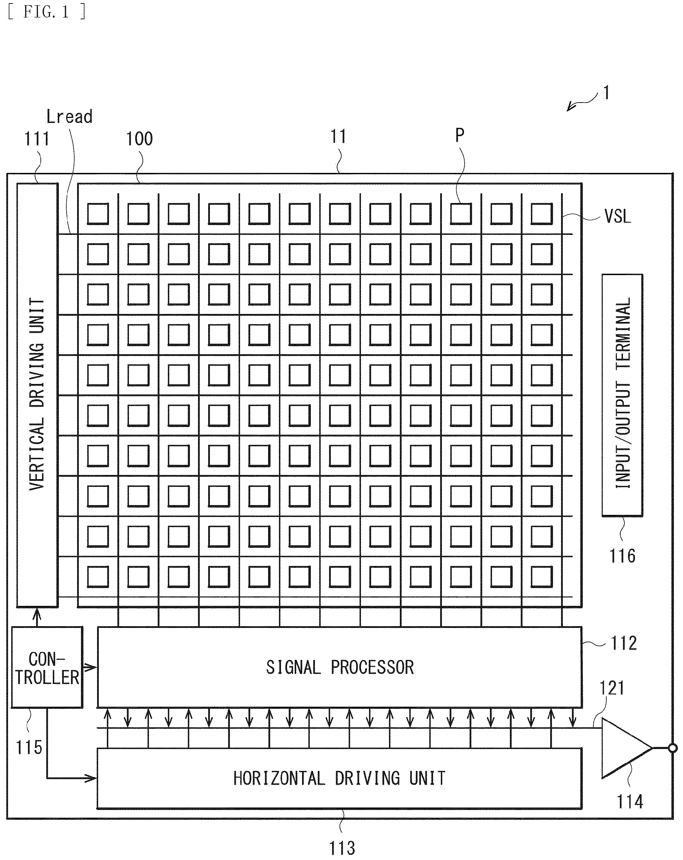

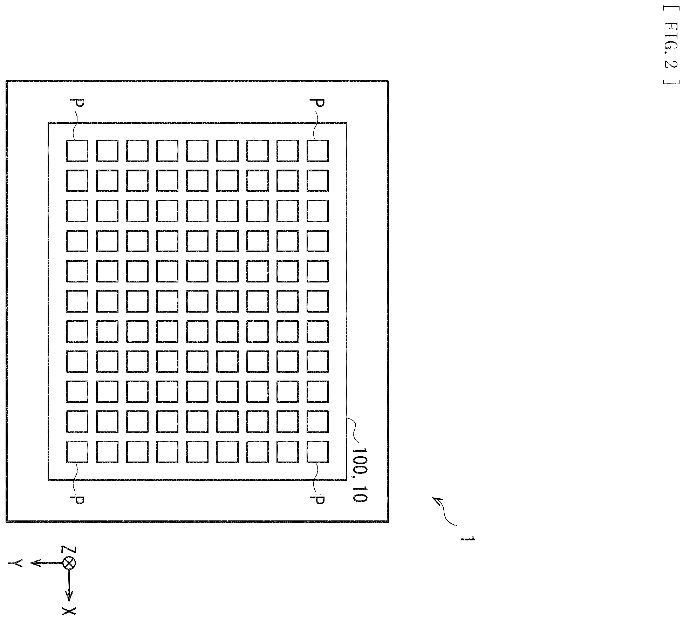

FIG. 1 is a block diagram illustrating an example of a schematic configuration of an imaging device according to a first embodiment of the present disclosure. FIG. 2 is a diagram illustrating an example of a pixel portion of the imaging device according to the first embodiment. An imaging device 1 includes a plurality of pixels P each including a photoelectric conversion unit and photoelectrically converts incident light to generate a signal. The photoelectric conversion unit is, for example, a photodiode and enables to photoelectrically converts light. As illustrated in FIG. 2, the imaging device 1 has a region (pixel portion 100) in which the plurality of pixels P is two-dimensionally arranged in a matrix, as an imaging area.

The imaging device 1 takes in incident light (image light) from an object, via an optical system (not illustrated) including an optical lens. The imaging device 1 images an image of the object formed by the optical lens. The imaging device 1 photoelectrically converts the received light and generates a pixel signal. The imaging device 1 is, for example, a Complementary Metal Oxide Semiconductor (CMOS) image sensor. It is possible to use the imaging device 1 for an electronic apparatus such as a digital still camera, a video camera, or a mobile phone.

Note that, as illustrated in FIG. 2, an incident direction of the light from the object is referred to as a Z-axis direction, a horizontal direction on paper perpendicular to the Z-axis direction is referred to as an X-axis direction, and a vertical direction on paper perpendicular to the Z-axis and the X-axis is referred to as a Y-axis direction. In the following drawings, directions may be described with reference to the arrow directions in FIG. 2.

As in the example illustrated in FIG. 1, the imaging device 1 includes, for example, a vertical driving unit 111, a signal processor 112, a horizontal driving unit 113, an output unit 114, a controller 115, an input/output terminal 116, or the like, in a peripheral region of the pixel portion 100.

In the imaging device 1, for example, a plurality of pixel driving lines Lread and a plurality of vertical signal lines VSL are provided. For example, in the pixel portion 100, the plurality of pixel driving lines Lread is wired, for each pixel row including the plurality of pixels P arranged in a horizontal direction (row direction). Furthermore, in the pixel portion 100, the vertical signal line VSL is wired, for each pixel column including the plurality of pixels P arranged in a vertical direction (column direction).

The pixel driving line Lread transmits a driving signal used to read a signal from the pixel P. The vertical signal line VSL is a signal line that enables to transfer the signal from the pixel P. The vertical signal line VSL transmits the signal outputted from the pixel P.

The vertical driving unit 111 includes a shift register, an address decoder, or the like. The vertical driving unit 111 drives each pixel P of the pixel portion 100. The vertical driving unit 111 is a pixel driving unit and generates a signal used to drive the pixel P and outputs the signal to each pixel P of the pixel portion 100 via the pixel driving line Lread. The vertical driving unit 111 generates, for example, a signal used to control a transfer transistor, a signal used to control a reset transistor, or the like and supplies the signal to each pixel P through the pixel driving line Lread.

The signal processor 112 executes signal processing on an inputted signal of the pixel. The signal processor 112 includes, for example, a load circuit unit, an Analog Digital (AD) conversion unit, a horizontal selection switch, or the like.

A signal, outputted from each pixel P, selectively scanned by the vertical driving unit 111 is supplied to the signal processor 112 through the vertical signal line VSL. The signal processor 112 executes signal processing, for example, AD conversion, Correlated Double Sampling (CDS), or the like.

The horizontal driving unit 113 includes a shift register, an address decoder, or the like. The horizontal driving unit 113 drives the horizontal selection switch of the signal processor 112. The horizontal driving unit 113 drives each horizontal selection switch of the signal processor 112 in sequence while scanning each horizontal selection switch. The signal processing is executed on the signal of each pixel P transmitted through each vertical signal line VSL by the signal processor 112, and the signal is outputted to a horizontal signal line 121 in sequence by selective scanning by the horizontal driving unit 113.

The output unit 114 executes the signal processing on an inputted signal and outputs a signal. The output unit 114 executes the signal processing on a signal of a pixel sequentially inputted from the signal processor 112 via the horizontal signal line 121 and outputs the processed signal. There is a case where the output unit 114 executes, for example, only buffering or executes black level adjustment, column variation correction, various types of digital signal processing, or the like.

A circuit portion including the vertical driving unit 111, the signal processor 112, the horizontal driving unit 113, the horizontal signal line 121, and the output unit 114 may be formed on a semiconductor substrate 11 or may be disposed on an external control integrated circuit (IC). Furthermore, the circuit portion may be formed on another substrate coupled with a cable or the like.

The controller 115 controls each unit of the imaging device 1. The controller 115 receives a clock given from outside of the semiconductor substrate 11, data that instructs an operation mode, or the like and also outputs data of internal information of the imaging device 1 or the like. The controller 115 includes a timing generator that generates various timing signals and drives and controls a peripheral circuit such as the vertical driving unit 111, the signal processor 112, or the horizontal driving unit 113, on the basis of the various timing signals generated by the timing generator. The input/output terminal 116 exchanges signals with outside.

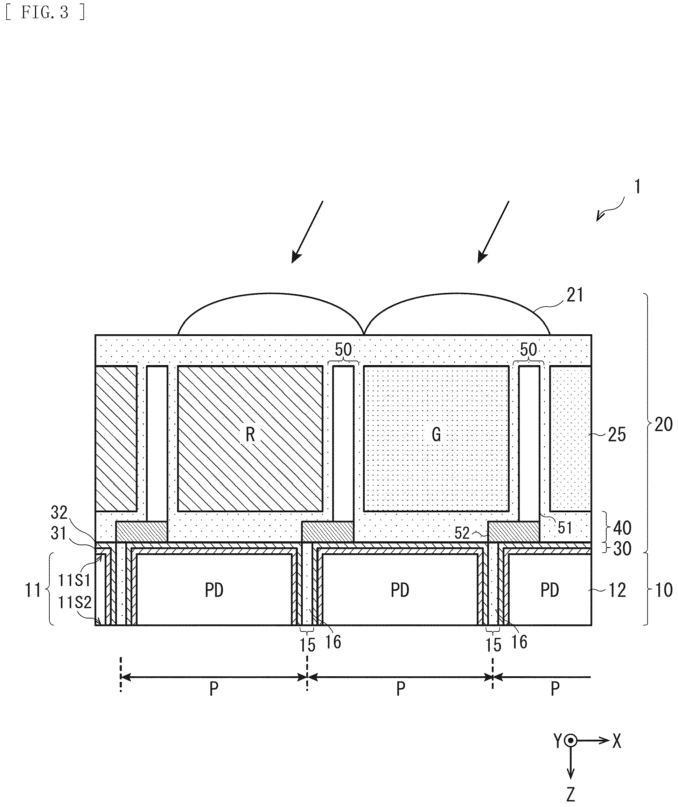

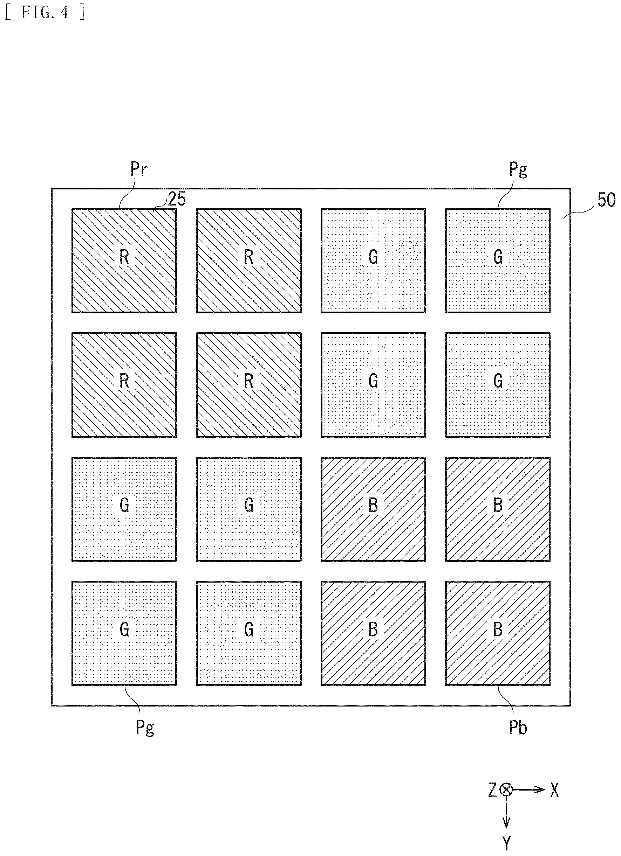

FIG. 3 is a diagram illustrating an example of a cross-sectional configuration of the imaging device according to the first embodiment. Furthermore, FIG. 4 is a diagram illustrating an example of a plane configuration of the imaging device according to the first embodiment. The imaging device 1 includes a light receiving unit 10 and a light guide unit 20. The light receiving unit 10 includes the semiconductor substrate 11 having a first surface 11S1 and a second surface 11S2 opposed to each other. Note that FIG. 3 illustrates an example of the cross-sectional configuration in a region with a long distance from the center of the pixel portion 100 (light receiving unit 10), that is, a high image height.

The light guide unit 20 is provided on a side of the first surface 11S1 of the semiconductor substrate 11. A multi-layer wiring layer (not illustrated) is provided on a side of the second surface 11S2 of the semiconductor substrate 11. The imaging device 1 has a configuration in which the light receiving unit 10, the light guide unit 20, and the multi-layer wiring layer are stacked in the Z-axis direction. It is also said that the light guide unit 20 is provided on a side where light from an optical lens system enters and the multi-layer wiring layer is provided on a side opposite to the side where the light enters. The imaging device 1 is a so-called back-illuminated imaging device.

The semiconductor substrate 11 includes, for example, a silicon substrate. A photoelectric conversion unit 12 is a photodiode (PD) and has pn junction in a predetermined region of the semiconductor substrate 11. The plurality of photoelectric conversion units 12 is embedded and formed in the semiconductor substrate 11. In the light receiving unit 10, the plurality of photoelectric conversion units 12 is provided along the first surface 11S1 and the second surface 11S2 of the semiconductor substrate 11.

The multi-layer wiring layer provided on the side of the second surface 11S2 of the semiconductor substrate 11 has, for example, a configuration in which a plurality of wiring layers is stacked with an interlayer insulation layer therebetween. The wiring layer of the multi-layer wiring layer is formed using, for example, aluminum (Al), copper (Cu), tungsten (W), or the like. The interlayer insulation layer is formed using, for example, silicon oxide (SiOx), silicon nitride (SiNx), silicon oxynitride (SiOxNy), or the like.

In the semiconductor substrate 11 and the multi-layer wiring layer, a circuit (for example, transfer transistor, reset transistor, amplification transistor, or the like) is formed that reads a pixel signal on the basis of a charge generated by the photoelectric conversion unit 12. Furthermore, in the semiconductor substrate 11 and the multi-layer wiring layer, for example, the vertical driving unit 111, the signal processor 112, the horizontal driving unit 113, the output unit 114, the controller 115, the input/output terminal 116, and the like described above are formed.

The light guide unit 20 is stacked on the light receiving unit 10 in a thickness direction perpendicular to the first surface 11S1 of the semiconductor substrate 11. The light guide unit 20 includes a lens unit 21 and a color filter 25 and guides light entering from above toward a side of the light receiving unit 10. The lens unit 21 is an optical member called an on-chip lens and is provided above the color filter 25 for each pixel P, for example. The light from the object enters the lens unit 21 via the optical system of the imaging device 1. The photoelectric conversion unit 12 photoelectrically converts the light that enters via the lens unit 21 and the color filter 25.

The color filter 25 selectively transmits light in a specific wavelength band of the incident light. The plurality of pixels P provided in the pixel portion 100 of the imaging device 1 includes a plurality of pixels Pr, pixels Pg, and pixels Pb, as illustrated in FIG. 4. In the pixel portion 100, the plurality of pixels Pr, the plurality of pixels Pg, and the plurality of pixels Pb are repeatedly arranged.

The pixel Pr is a pixel in which the color filter 25 that transmits red (R) light is provided. The red color filter 25 transmits light in a red wavelength band. The photoelectric conversion unit of the pixel Pr receives light of a red wavelength and performs photoelectric conversion. The pixel Pr is a pixel that receives light in the red wavelength band and generates a signal. Furthermore, the pixel Pg is a pixel in which the color filter 25 that transmits green (G) light is provided. The green color filter 25 transmits light in a green wavelength band. The photoelectric conversion unit of the pixel Pg receives light of a green wavelength and performs photoelectric conversion. The pixel Pg is a pixel that receives light in the green wavelength band and generates a signal.

The pixel Pb is a pixel in which the color filter 25 that transmits blue (B) light is provided. The blue color filter 25 transmits light in a blue wavelength band. The photoelectric conversion unit of the pixel Pb receives light of a blue wavelength and performs photoelectric conversion. The pixel Pb is a pixel that receives light in the blue wavelength band and generates a signal. The pixel Pr, the pixel Pg, and the pixel Pb respectively generate a pixel signal of an R component, a pixel signal of a G component, and a pixel signal of a B component. Therefore, it is possible for the imaging device 1 to obtain the pixel signal of RGB.

Furthermore, as illustrated in FIG. 3., in the imaging device 1, a separation unit 15, a metal compound layer 30, and an oxide film layer 40 are provided. The separation unit 15 is provided between the adjacent photoelectric conversion units 12 and separates between the photoelectric conversion units 12. The separation unit 15 has a trench structure provided at a boundary between the adjacent pixels P (or photoelectric conversion unit 12) and is said as an inter-pixel separation unit or an inter-pixel separation wall.

The separation unit 15 includes a trench 16 (groove portion). The trench 16 of the separation unit 15 is provided around the photoelectric conversion unit 12, in the semiconductor substrate 11. In the trench 16, for example, an oxide film is provided. In the example illustrated in FIG. 3, the trench 16 (groove) is formed between the adjacent photoelectric conversion units 12, and the oxide film is embedded in the trench 16.

The metal compound layer 30 is provided on the photoelectric conversion unit 12 between the color filter 25 and the photoelectric conversion unit 12. The metal compound layer 30 includes a metal compound. The metal compound layer 30 is a layer including, for example, metal oxide or metal nitride.

The metal compound layer 30 includes a fixed charge film 31 and an antireflection film 32. The fixed charge film 31 is a film having a fixed charge and is formed using a high dielectric. The fixed charge film 31 includes metal oxide, for example, hafnium oxide or the like and is provided on the photoelectric conversion unit 12. The fixed charge film 31 is formed between the photoelectric conversion unit 12 and the separation unit 15.

In the example illustrated in FIG. 3, the fixed charge film 31 is provided to cover the photoelectric conversion unit 12. The fixed charge film 31 is a film, for example, having a negative fixed charge and prevents generation of a dark current at an interface of the semiconductor substrate 11. The fixed charge film 31 is formed to include at least one of oxides, for example, hafnium (Hf), zirconium (Zr), aluminum (Al), titanium (Ti), tantalum (Ta), magnesium (Mg), yttrium (Y), a lanthanoid (La) element, and the like.

Note that the fixed charge film 31 may include praseodymium oxide, cerium oxide, neodymium oxide, promethium oxide, samarium oxide, europium oxide, gadolinium oxide, terbium oxide, dysprosium oxide, holmium oxide, thulium oxide, ytterbium oxide, lutetium oxide, yttrium oxide, or the like. Furthermore, the fixed charge film 31 may be configured using metal nitride or metal oxynitride such as an aluminum nitride film, a hafnium oxynitride film, or an aluminum oxynitride film. As the fixed charge film 31, a film having a positive fixed charge may be provided.

The antireflection film 32 includes metal oxide, for example, tantalum oxide or the like and is provided on the fixed charge film 31. The antireflection film 32 is provided between the fixed charge film 31 and the oxide film layer 40 and reduces reflection. The antireflection film 32 may include other metal oxide films other than tantalum oxide or may include a metal nitride film or a metal oxynitride film. In the separation unit 15, as in the example illustrated in FIG. 3, the fixed charge film 31 and the antireflection film 32 may be formed to cover side surfaces of the trench 16.

The oxide film layer 40 is provided between the color filter 25 and the metal compound layer 30. The oxide film layer 40 is formed using silicon oxide (SiOx), for example. The oxide film layer 40 includes a silicon dioxide film, a silicon oxynitride film, or the like. Note that the oxide film layer 40 is also said as a planarization layer (planarization film).

Furthermore, the imaging device 1 includes a structure 50 as illustrated in FIG. 3. A portion of the structure 50 is provided between the adjacent color filters 25 and separates between the color filters 25. The structure 50 is also said as a separation wall (or separation unit) that has an air gap (cavity) provided between the adjacent color filters 25 and uses the air gap (cavity).

The structure 50 is provided from between the adjacent color filters 25 to the metal compound layer 30 and is coupled to the separation unit 15. The structure 50 extends to between the oxide film layer 40 and the metal compound layer 30, as illustrated in FIG. 3. A portion of the structure 50 is formed on the metal compound layer 30 and has contact with the metal compound layer 30. Furthermore, as illustrated in FIG. 4, the structure 50 is provided around the color filter 25.

As illustrated in FIG. 3, the structure 50 includes a first section 51 provided between the adjacent color filters 25 and a second section 52 provided to the separation unit 15 along the metal compound layer 30. The first section 51 of the structure 50 is positioned between the adjacent color filters 25 and has a refractive index lower than a refractive index of a surrounding medium.

The first section 51 of the structure 50 has the refractive index lower than a refractive index of the color filter 25. In the present embodiment, the first section 51 has air (air gap). The first section 51 of the structure 50 is a light guide unit and changes a traveling direction of incident light, in accordance with a refractive index difference between the first section 51 and the surrounding medium. It is also said that the imaging device 1 has a waveguiding structure that guides light using the first section 51 of the structure 50.

The second section 52 of the structure 50 includes a member that shields light and is provided on the metal compound layer 30. The second section 52 of the structure 50 includes, for example, titanium nitride (TiN) and couples the first section 51 and the separation unit 15. It is also said that the second section 52 is a connection unit (or coupling unit) that connects the first section 51 and the trench 16 of the separation unit 15.

The second section 52 of the structure 50 couples the first section 51 and the separation unit 15 and prevents leakage of light to the surrounding pixels P. Note that the second section 52 of the structure 50 may include a metal film that absorbs light. For example, the second section 52 may include tungsten (W).

The light from the optical lens almost perpendicularly enters a middle portion of the pixel portion 100 of the imaging device 1. On the other hand, as in the example indicated by an arrow in FIG. 3, the light obliquely enters a peripheral portion positioned on an outer side of the middle portion, that is, a region apart from the middle of the pixel portion 100. Therefore, in the imaging device 1, positions of the lens unit 21 and the color filter 25 in each pixel P are set to differ depending on a distance from the center of the pixel portion 100 (light receiving unit 10), that is, the height.

As illustrated in FIG. 3, the lens unit 21 and the color filter 25 of the pixel P are arranged to be shifted to the middle side of the pixel portion 100 (light receiving unit 10), with respect to the photoelectric conversion unit 12 of the pixel P. The structure 50 includes the second section 52 having a size that differs depending on the distance from the center of the light receiving unit 10. For example, as a region is positioned farther from the middle of the pixel portion 100, a width (area) of the second section 52 of the structure 50 in that region is wider.

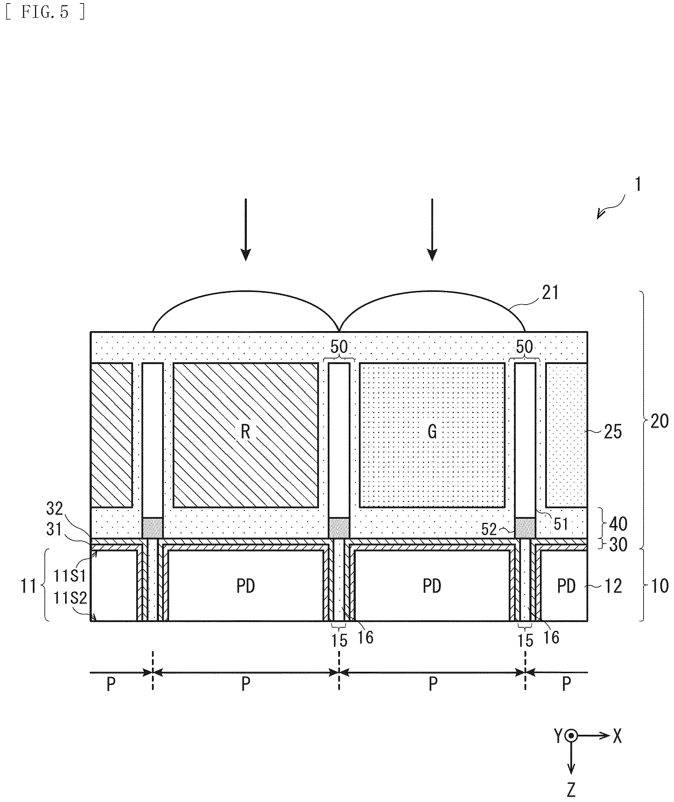

Note that, in a middle region of the pixel portion 100, the pixel P is configured, for example, as illustrated in FIG. 5. In the pixel P at the middle of the pixel portion 100, as in the example illustrated in FIG. 5, respective center positions of the lens unit 21, the color filter 25, the photoelectric conversion unit 12 substantially match.

In this way, in the imaging device 1, the position of each of the lens unit 21 and the color filter 25 is adjusted in accordance with the height, and it is possible to appropriately perform pupil correction. It is possible to suppress decrease in an amount of the light for entering the photoelectric conversion unit 12 and to prevent reduction in sensitivity for the incident light.

Furthermore, in the imaging device 1 according to the present embodiment, by providing the structure 50, it is possible to prevent the leakage of the light to the surrounding pixels and prevent occurrence of color mixture. It is possible for the structure 50 to propagate the incident light toward the side of the photoelectric conversion unit 12 and to improve the sensitivity for the incident light.

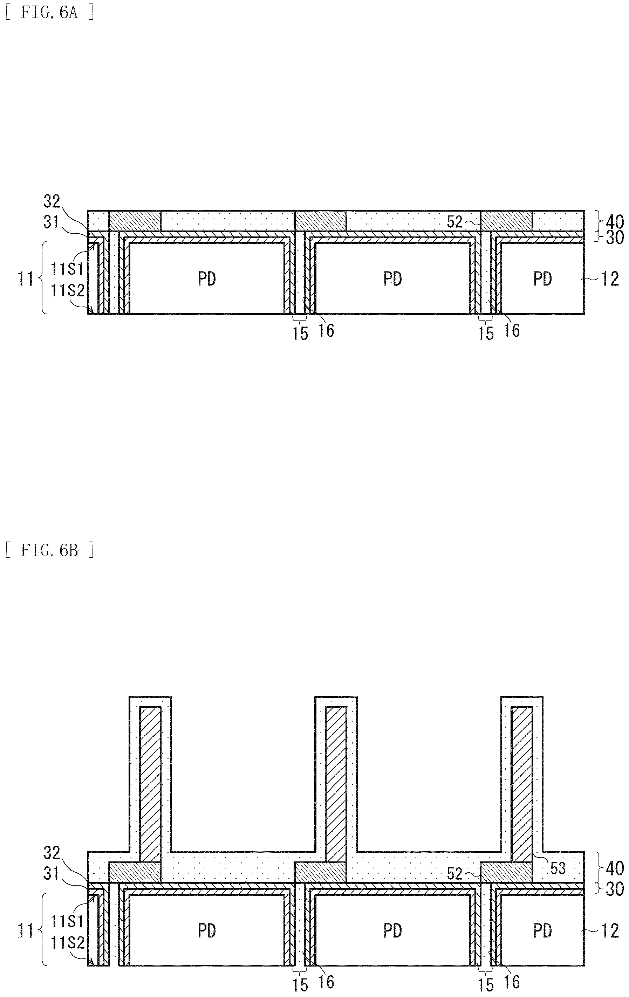

FIGs. 6A to 6D are diagrams illustrating an example of a method for manufacturing the imaging device according to the first embodiment. First, as illustrated in FIG. 6A, on the semiconductor substrate 11, on which elements such as the photoelectric conversion unit 12 are formed, the metal compound layer 30 is formed. Furthermore, as the second section 52 of the structure 50, a titanium nitride film is formed, and as the oxide film layer 40, a silicon dioxide film is formed. Then, by CMP or etch-back processing, an extra silicon dioxide film is removed.

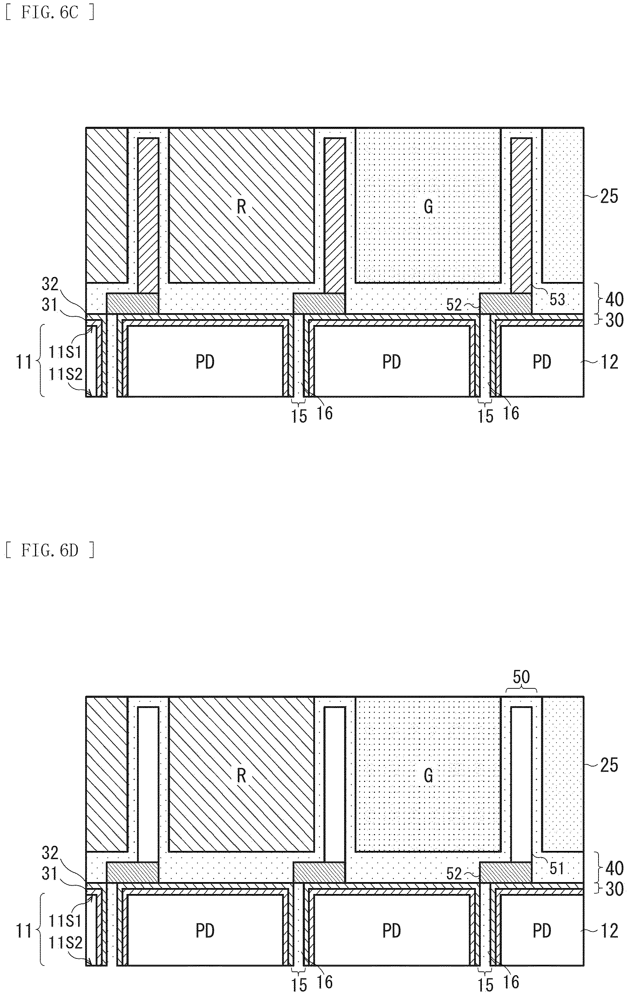

Next, as illustrated in FIG. 6B, an a-Si film 53 (amorphous silicon film) is formed, and a silicon dioxide film is formed, as a protection film, around the a-Si film 53. Furthermore, as illustrated in FIG. 6C, the color filter 25 is formed. Then, a hole (opening) is formed in a portion of the silicon dioxide film on the a-Si film 53, and etching is performed on the a-Si film 53 via the hole. As a result, the air gap of the first section 51 of the structure 50 is formed. Note that the hole of the silicon dioxide film may be arranged at corners (corner portion) of the pixel P, for example, four corners, in planar view.

After the air gap is formed, for example, the hole is closed by the silicon dioxide film. As a result, as illustrated in FIG. 6D, the structure 50 having the air gap of the first section 51 is formed. According to the above manufacturing method, it is possible to manufacture the imaging device 1 illustrated in FIG. 3 or the like. Note that the above manufacturing method is merely an example, and another manufacturing method may be adopted.

### [Workings and Effect]

The imaging device (imaging device 1) according to the present embodiment includes the plurality of pixels (pixel P) including the photoelectric conversion unit (photoelectric conversion unit 12) that photoelectrically converts light, the color filter (color filter 25) provided for each pixel, the separation unit (15) provided between the adjacent photoelectric conversion units, the structure (structure 50) having the air gap provided between the adjacent color filters, and the metal compound layer (metal compound layer 30) provided on the photoelectric conversion unit, between the color filter and the photoelectric conversion unit. The structure is provided from between the adjacent color filters and to the metal compound layer and is coupled to the separation unit.

In the imaging device 1 according to the present embodiment, the structure 50 having the air gap is provided from between the adjacent color filters 25 to the metal compound layer 30 and is coupled to the separation unit 15. Therefore, it is possible to prevent the occurrence of the color mixture between the pixels. It is possible to realize the imaging device 1 that enables to reduce the color mixture.

Furthermore, in the present embodiment, the structure 50 includes the first section 51 provided between the adjacent color filters 25 and the second section 52 provided to the separation unit 15 along the metal compound layer 30. The first section 51 has the air gap, and the second section 52 includes the metal film. By providing the structure 50 in which the first section 51 having the air gap and the second section 52 including the metal film are stacked, it is possible to effectively prevent the occurrence of the color mixture. It is possible to prevent deterioration in image quality of an image.

Next, a modification example of the present disclosure is described. Hereinafter, a component similar to that in the embodiment is denoted with the same reference numeral, and description thereof is appropriately omitted.

### (1-1. First Modification Example)

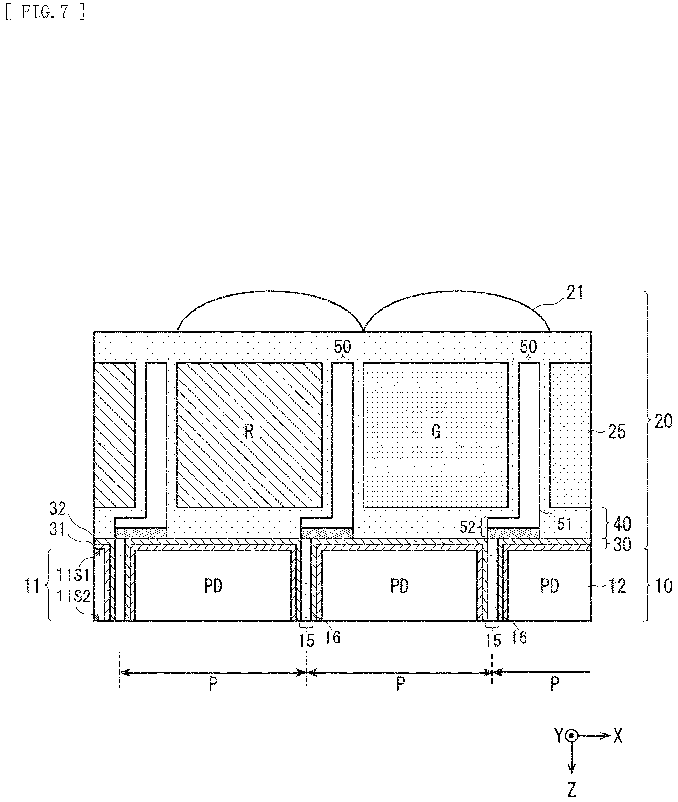

FIG. 7 is a diagram illustrating an example of the cross-sectional configuration of the imaging device according to a first modification example of the present disclosure. The second section 52 of the structure 50 may have an air gap and a metal film. In the example illustrated in FIG. 7, the second section 52 of the structure 50 includes the metal film (for example, titanium nitride film) stacked on the metal compound layer 30 and the air gap provided to be stacked on the metal film. In a case of the present modification example, it is possible to obtain an effect similar to that in the above embodiment.

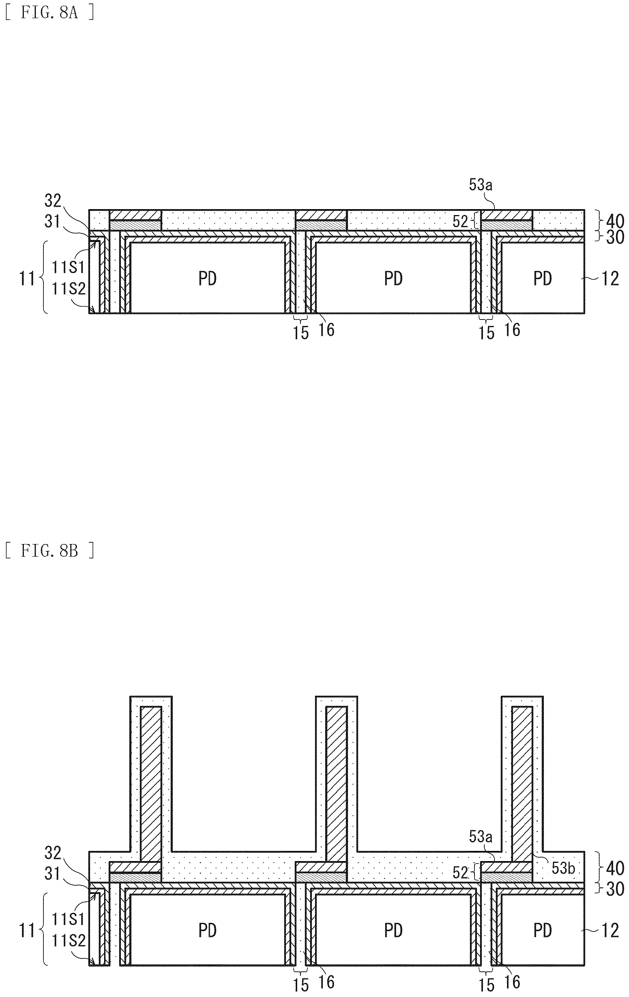

FIGs. 8A to 8D are diagrams illustrating an example of a method for manufacturing the imaging device according to the first modification example. First, as illustrated in FIG. 8A, on the semiconductor substrate 11, on which the elements such as the photoelectric conversion unit 12 are formed, the metal compound layer 30 is formed. Furthermore, the titanium nitride film and an a-Si film 53a that are the second section 52 of the structure 50 are formed, and as the oxide film layer 40, a silicon dioxide film is formed. Then, by the CMP or the etch-back processing, the extra silicon dioxide film is removed.

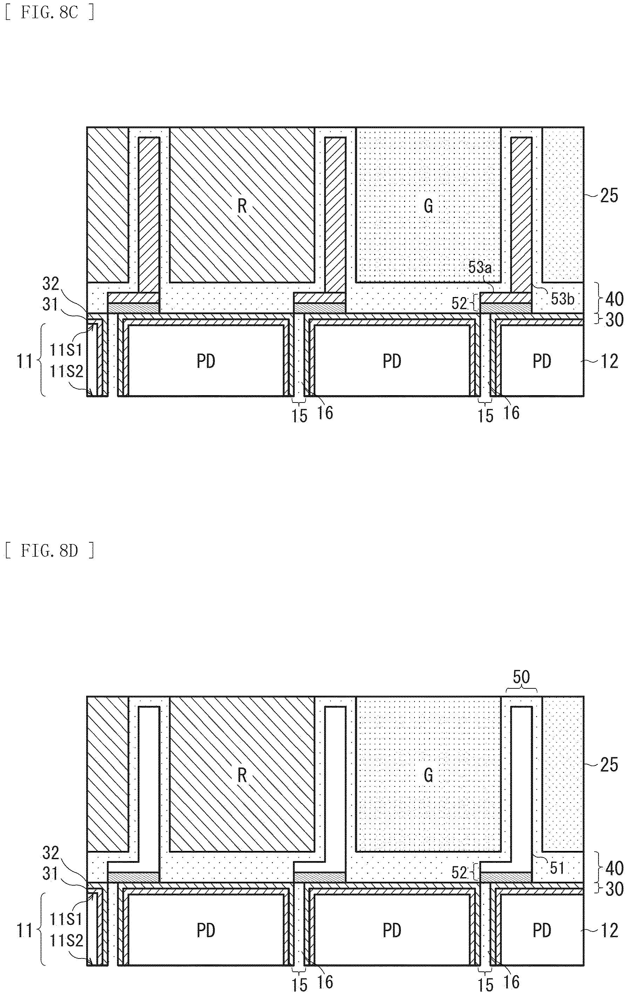

Next, as illustrated in FIG. 8B, an a-Si film 53b is formed, and a silicon dioxide film is formed, as a protection film, around the a-Si films 53a and 53b. Then, as illustrated in FIG. 8C, the color filter 25 is formed.

Next, a hole (opening) is formed in a portion of the silicon dioxide film on the a-Si film 53b, and etching is performed on the a-Si films 53b and 53a via the hole. As a result, the air gap that is the first section 51 of the structure 50 is formed. By closing the hole by the silicon dioxide film after the air gap is formed, the structure 50 having the air gap is formed as illustrated in FIG. 8D. According to the above manufacturing method, it is possible to manufacture the imaging device 1 illustrated in FIG. 7.

### (1-2. Second Modification Example)

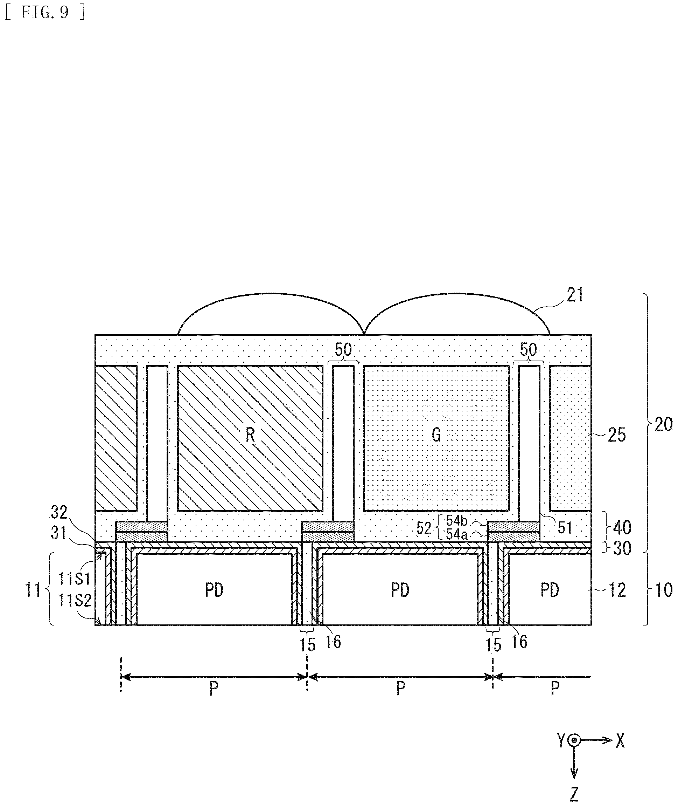

FIG. 9 is a diagram illustrating an example of the cross-sectional configuration of the imaging device according to a second modification example. The second section 52 of the structure 50 may include a plurality of types of metal films. As illustrated in FIG. 9, the second section 52 of the structure 50 may have a configuration in which a first metal film 54a and a second metal film 54b are stacked.

For example, the first metal film 54a includes a titanium nitride film and is provided on the metal compound layer 30. Furthermore, the second metal film 54b includes a tungsten film and is provided on the first metal film 54a. Note that the first metal film 54a and the second metal film 54b may include other metal materials.

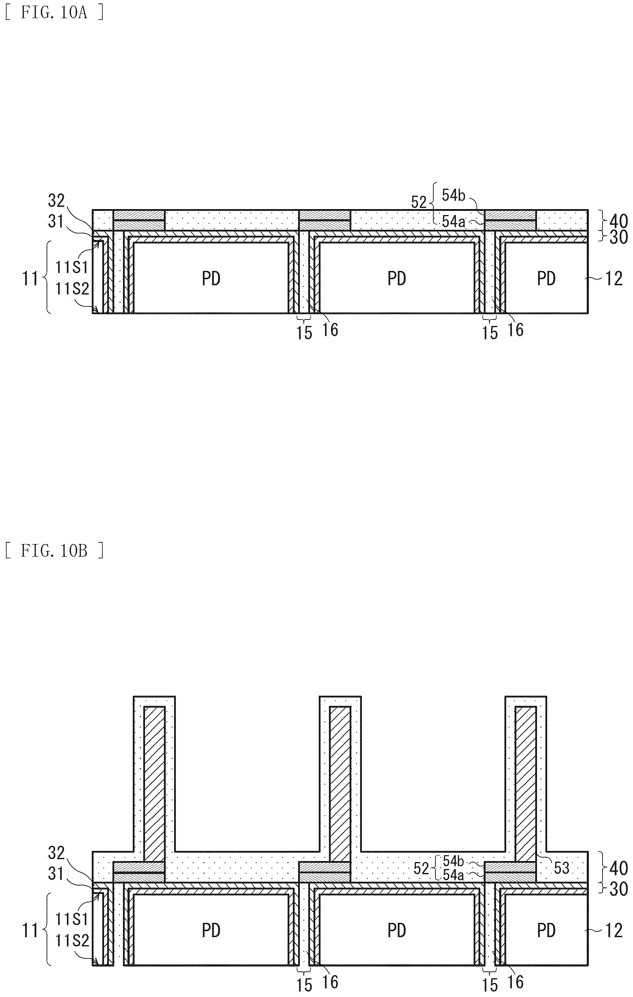

FIGs. 10A to 10D are diagrams illustrating an example of a method for manufacturing the imaging device according to the second modification example. First, as illustrated in FIG. 10A, on the semiconductor substrate 11, on which the elements such as the photoelectric conversion unit 12 are formed, the metal compound layer 30 is formed. Furthermore, the titanium nitride film that is the first metal film 54a, the tungsten film that is the second metal film 54b, and the silicon dioxide film as the oxide film layer 40 are formed. Then, by the CMP or the etch-back processing, the extra silicon dioxide film is removed.

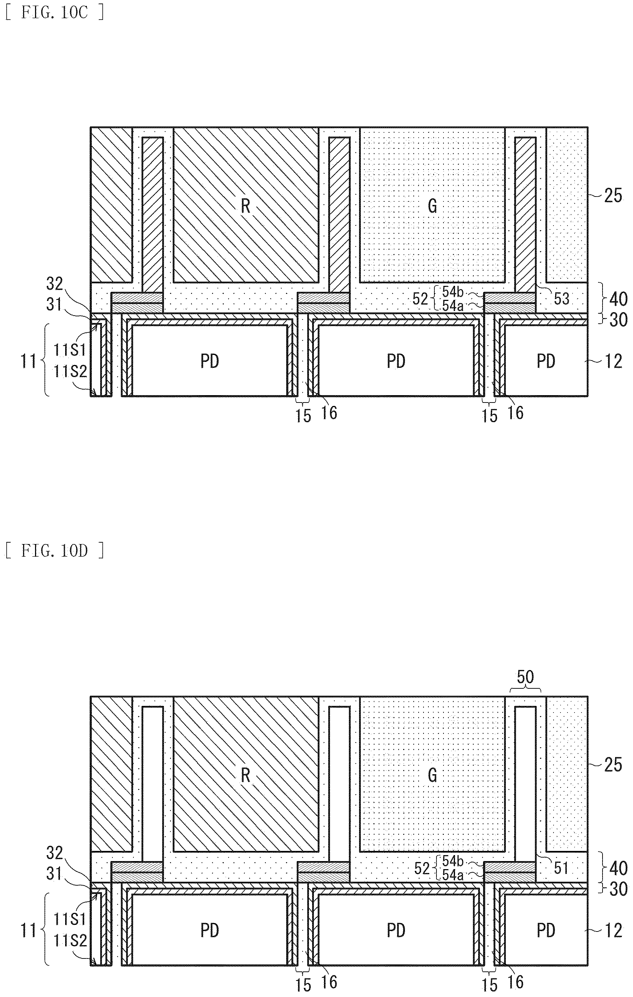

Next, as illustrated in FIG. 10B, the a-Si film 53 is formed, and a silicon dioxide film is formed, as a protection film, around the a-Si film 53. Then, as illustrated in FIG. 10C, the color filter 25 is formed.

Next, a hole is formed in a portion of the silicon dioxide film on the a-Si film 53, and etching is performed on the a-Si film 53 via the hole. As a result, the air gap of the first section 51 of the structure 50 is formed. By closing the hole by the silicon dioxide film after the air gap is formed, the structure 50 having the air gap is formed as illustrated in FIG. 10D. According to the above manufacturing method, it is possible to manufacture the imaging device 1 illustrated in FIG. 9.

### (1-3. Third Modification Example)

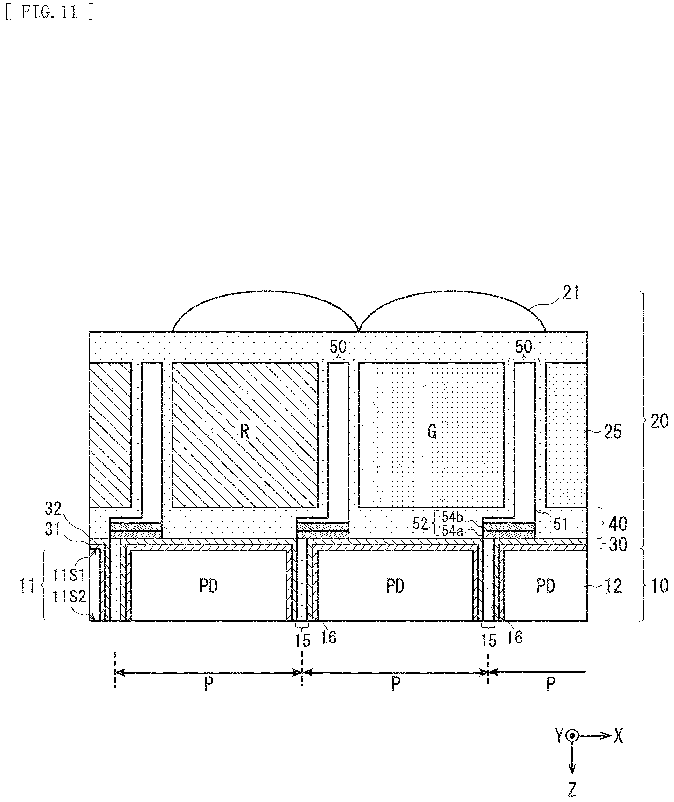

FIG. 11 is a diagram illustrating an example of the cross-sectional configuration of the imaging device according to a third modification example. The second section 52 of the structure 50 may have the air gap and the plurality of metal films. In the example illustrated in FIG. 11, the second section 52 of the structure 50 includes the first metal film 54a stacked on the metal compound layer 30, the second metal film 54b stacked on the first metal film 54a, and the air gap stacked on the second metal film 54b.

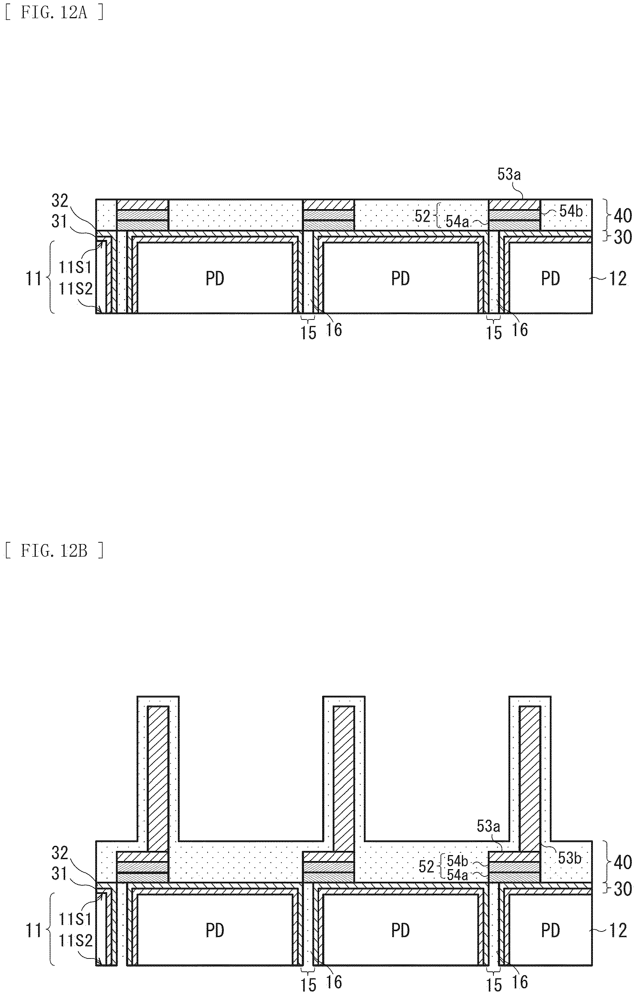

FIGs. 12A to 12D are diagrams illustrating an example of a method for manufacturing the imaging device according to the third modification example. First, as illustrated in FIG. 12A, on the semiconductor substrate 11, on which the elements such as the photoelectric conversion unit 12 are formed, the metal compound layer 30 is formed. Furthermore, as the second section 52 of the structure 50, the first metal film 54a, the second metal film 54b, and the a-Si film 53a are formed, and as the oxide film layer 40, a silicon dioxide film is formed. Then, by the CMP or the etch-back processing, the extra silicon dioxide film is removed.

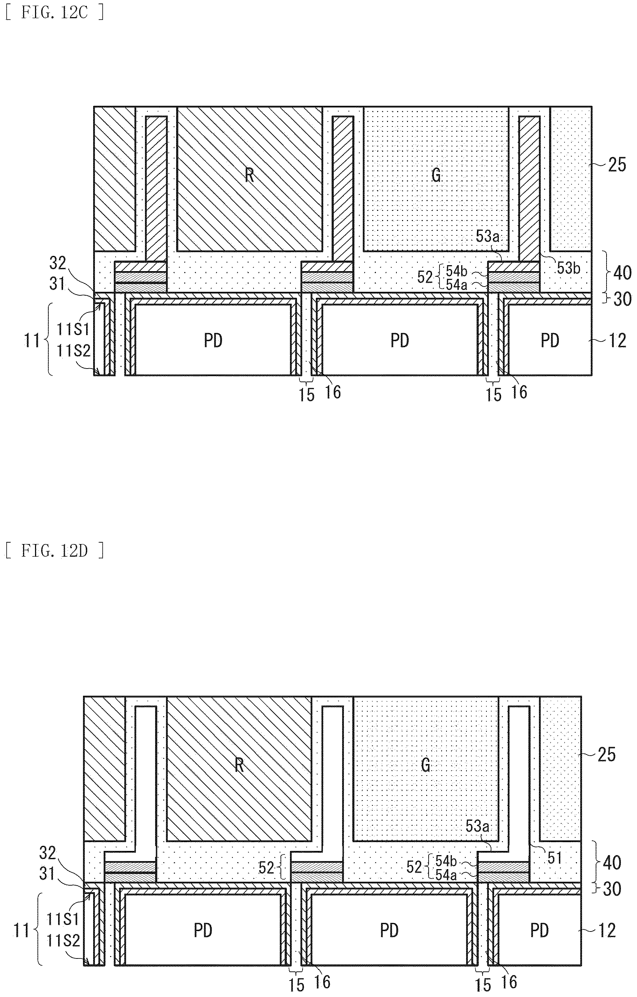

Next, as illustrated in FIG. 12B, the a-Si film 53b is formed, and a silicon dioxide film is formed, as a protection film, around the a-Si films 53a and 53b. Then, as illustrated in FIG. 12C, the color filter 25 is formed.

Next, a hole is formed in a portion of the silicon dioxide film on the a-Si film 53b, and etching is performed on the a-Si films 53b and 53a via the hole. As a result, the air gap of the structure 50 is formed. By closing the hole by the silicon dioxide film after the air gap is formed, the structure 50 having the air gap is formed as illustrated in FIG. 12D. According to the above manufacturing method, it is possible to manufacture the imaging device 1 illustrated in FIG. 11.

### (1-4. Fourth Modification Example)

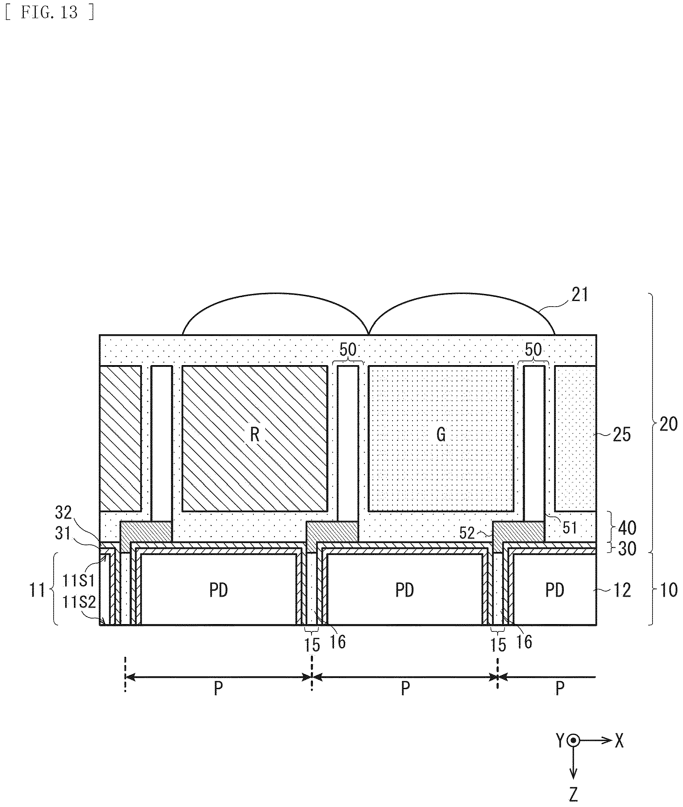

FIG. 13 is a diagram illustrating an example of the cross-sectional configuration of the imaging device according to a fourth modification example. As illustrated in FIG. 13, a portion of the structure 50 may be provided in the separation unit 15. In the example illustrated in FIG. 13, a portion of the second section 52 of the structure 50 is embedded and formed in the separation unit 15. In a case of the present modification example, it is possible to obtain an effect similar to that in the above embodiment.

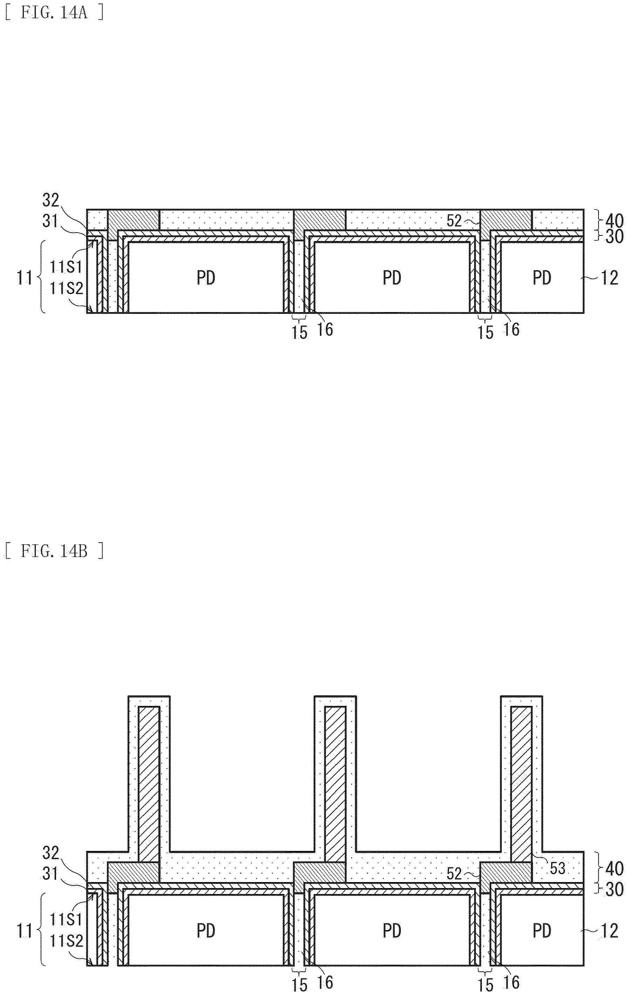

FIGs. 14A to 14D are diagrams illustrating an example of a method for manufacturing the imaging device according to the fourth modification example. First, as illustrated in FIG. 14A, on the semiconductor substrate 11, on which the elements such as the photoelectric conversion unit 12 are formed, the metal compound layer 30 is formed. Furthermore, the titanium nitride film that is the second section 52 of the structure 50 and the silicon dioxide film as the oxide film layer 40 are formed. A portion of the second section 52 of the structure 50 is embedded and formed in the separation unit 15. Then, by the CMP or the etch-back processing, the extra silicon dioxide film is removed.

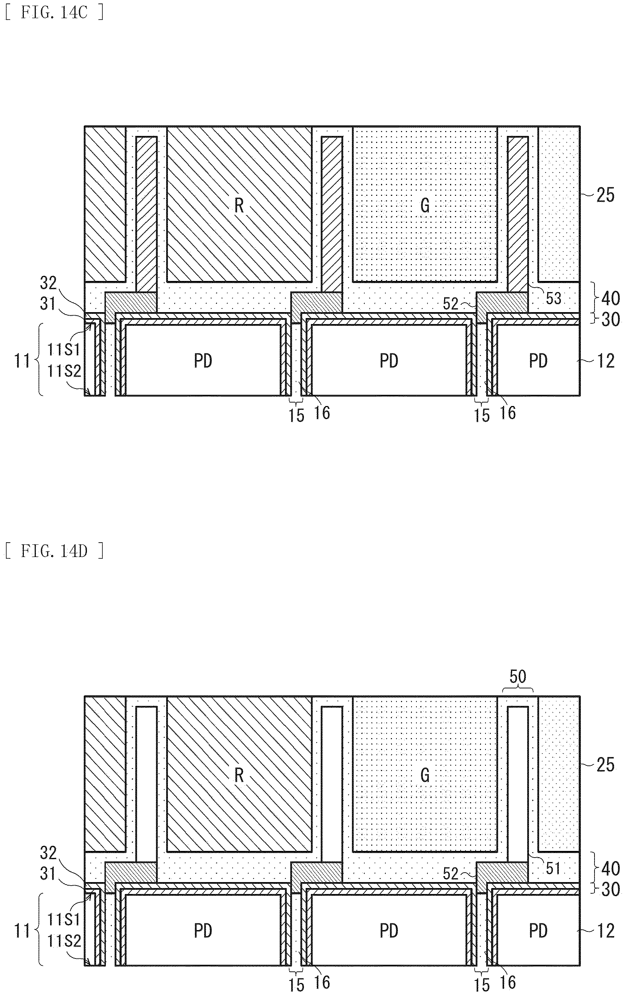

Next, as illustrated in FIG. 14B, the a-Si film 53 is formed, and a silicon dioxide film is formed, as a protection film, around the a-Si film 53. Then, as illustrated in FIG. 14C, the color filter 25 is formed.

Next, a hole is formed in a portion of the silicon dioxide film on the a-Si film 53, and etching is performed on the a-Si film 53 via the hole. As a result, the air gap of the first section 51 of the structure 50 is formed. By closing the hole by the silicon dioxide film after the air gap is formed, the structure 50 having the air gap is formed as illustrated in FIG. 14D. According to the above manufacturing method, it is possible to manufacture the imaging device 1 illustrated in FIG. 13.

### <2. Second Embodiment>

Next, a second embodiment according to the present disclosure is described. Hereinafter, a component similar to that in the embodiment is denoted with the same reference numeral, and description thereof is appropriately omitted.

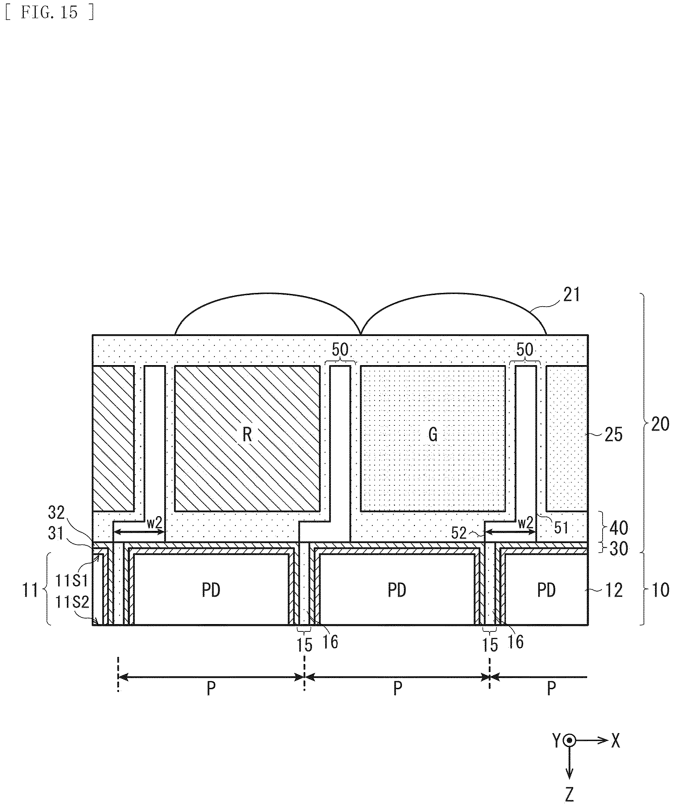

FIG. 15 is a diagram illustrating an example of a cross-sectional configuration of an imaging device according to the second embodiment of the present disclosure. FIG. 15 illustrates an example of a cross-sectional configuration of a region with a long distance from a center of a pixel portion 100 (light receiving unit 10), that is, with a high image height. In the present embodiment, a second section 52 of a structure 50 has air (air gap). Both of a first section 51 and the second section 52 have the air gap, and it is also said that the first section 51 and the second section 52 are continuously provided.

The second section 52 of the structure 50 is a light guide unit and changes a traveling direction of incident light, in accordance with a refractive index difference between the second section 52 and a surrounding medium. It is also said that an imaging device 1 have a waveguiding structure that guides light using the first section 51 and the second section 52 of the structure 50.

In the imaging device 1 according to the present embodiment, by providing the first section 51 and the second section 52 having the air gap, it is possible to prevent leakage of light to surrounding pixels P and to prevent occurrence of color mixture. Furthermore, it is possible for the structure 50 having the air gap to effectively guide light to a photoelectric conversion unit 12, and it is possible to improve sensitivity for the incident light.

Furthermore, the second section 52 of the structure 50 has the air gap and is formed to have contact with a metal compound layer 30. As compared with a case where a material with a low refractive index is formed in an oxide film layer, it is possible to reduce difficulty in manufacturing the imaging device 1.

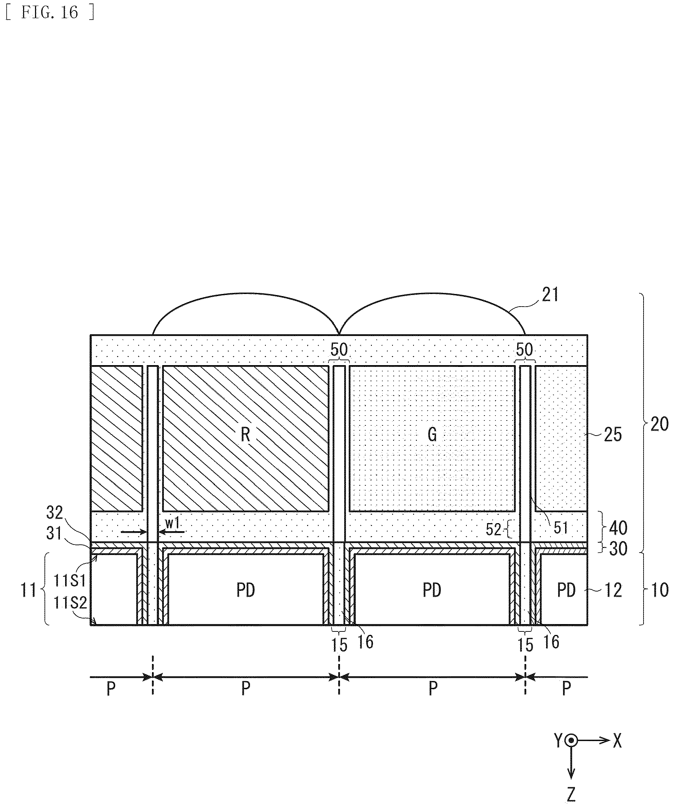

Note that, in a middle region of the pixel portion 100, the pixel P is configured, for example, as illustrated in FIG. 16. In the pixel P at the middle of the pixel portion 100, as in the example illustrated in FIG. 16, respective center positions of a lens unit 21, a color filter 25, and the photoelectric conversion unit 12 substantially match.

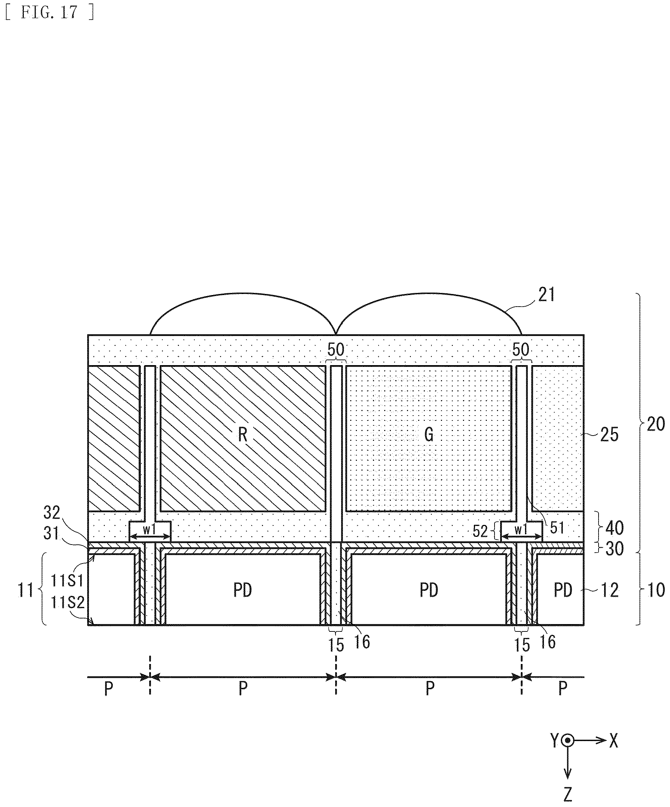

Furthermore, a width w1 (refer to FIG. 16) of the second section 52 of the structure 50 in a middle portion of the pixel portion 100 is less than a width w2 (refer to FIG. 15) of the second section 52 of the structure 50 in a peripheral portion positioned on an outer side than the middle portion. Note that, as illustrated in FIG. 17, the width w1 of the second section 52 of the structure 50 in the middle portion of the pixel portion 100 may be substantially equal to the width w2 of the second section 52 illustrated in FIG. 15.

### [Workings and Effect]

The imaging device (imaging device 1) according to the present embodiment includes the plurality of pixels (pixel P) including the photoelectric conversion unit (photoelectric conversion unit 12) that photoelectrically converts light, the color filter (color filter 25) provided for each pixel, a separation unit (separation unit 15) provided between the adjacent photoelectric conversion units, the structure (structure 50) having the air gap (first section 51 and second section 52) provided between the adjacent color filters, and the metal compound layer (metal compound layer 30) provided on the photoelectric conversion unit between the color filter and the photoelectric conversion unit. The structure is provided from between the adjacent color filters to the metal compound layer and is coupled to the separation unit.

In the imaging device 1 according to the present embodiment, the structure 50 is provided from between the adjacent color filters 25 to the metal compound layer 30 and is coupled to the separation unit 15. Therefore, it is possible to prevent the occurrence of the color mixture. It is possible to realize the imaging device 1 that enables to reduce the color mixture.

Furthermore, in the present embodiment, the structure 50 includes the first section 51 provided between the adjacent color filters 25 and the second section 52 provided to the separation unit 15 along the metal compound layer 30. The first section 51 and the second section 52 have the air gap. By providing the structure 50 having the air gap, it is possible to effectively prevent the occurrence of the color mixture. Furthermore, it is possible to efficiently guide light to the photoelectric conversion unit 12, and it is possible to improve the sensitivity for the incident light. It is possible to prevent deterioration in image quality of an image.

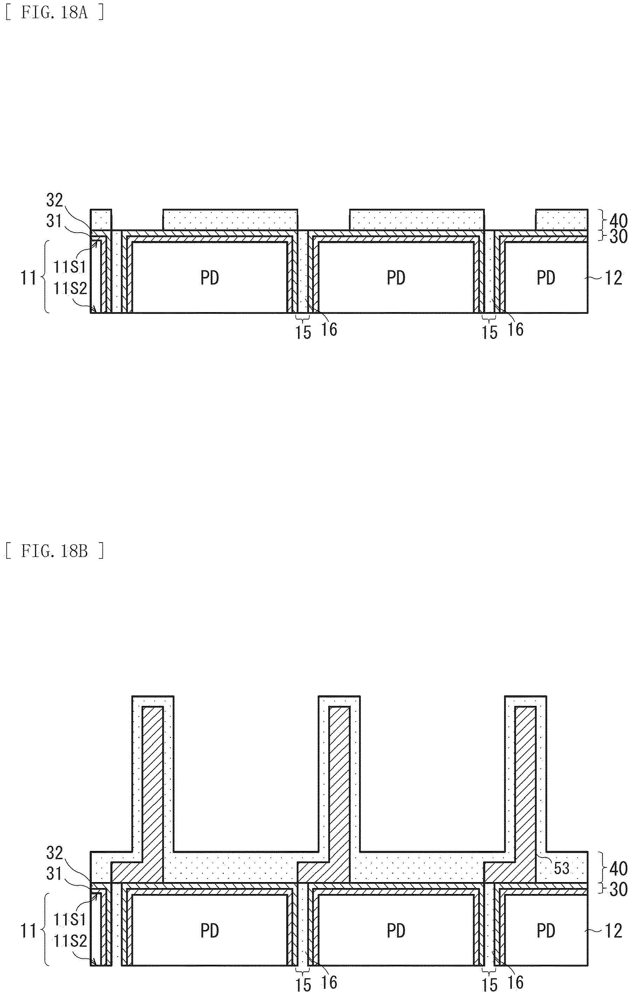

FIGs. 18A to 18D are diagrams illustrating an example of a method for manufacturing the imaging device according to the second embodiment. First, as illustrated in FIG. 18A, on a semiconductor substrate 11, on which elements such as the photoelectric conversion unit 12 are formed, the metal compound layer 30 is formed. Furthermore, as an oxide film layer 40, a silicon dioxide film is formed.

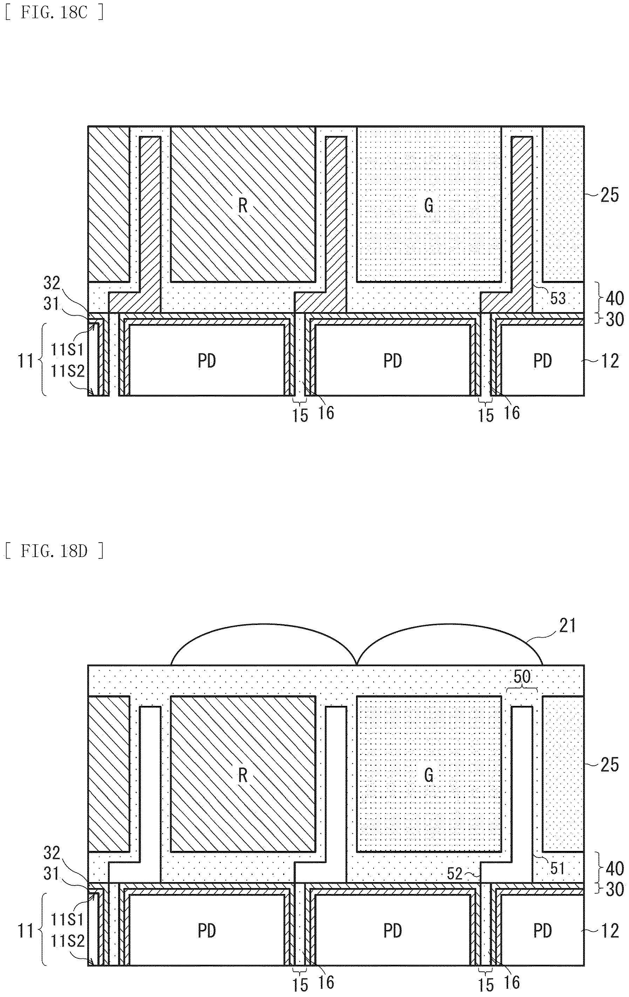

Next, as illustrated in FIG. 18B, for example, an a-Si film 53 (amorphous silicon film) is formed by chemical vapor deposition (CVD), and a silicon dioxide film is formed, as a protection film, around the a-Si film 53. Furthermore, as illustrated in FIG. 18C, the color filter 25 is formed. Then, holes (through-hole) are formed in a portion of the silicon dioxide film on the a-Si film 53, for example, at four corners of the pixel P, and etching is performed on the a-Si film 53 via the hole. As a result, the air gap of the first section 51 of the structure 50 is formed.

After the air gap is formed, for example, the hole is closed by a silicon dioxide film. As a result, as illustrated in FIG. 18D, the structure 50 having the air gap of the first section 51 is formed. Then, by forming the lens unit 21 or the like, it is possible to manufacture the imaging device 1 illustrated in FIG. 15 or the like. Note that the above manufacturing method is merely an example, and another manufacturing method may be adopted.

Next, a modification example of the present disclosure is described. Hereinafter, a component similar to that in the embodiment is denoted with the same reference numeral, and description thereof is appropriately omitted.

### (2-1. Fifth Modification Example)

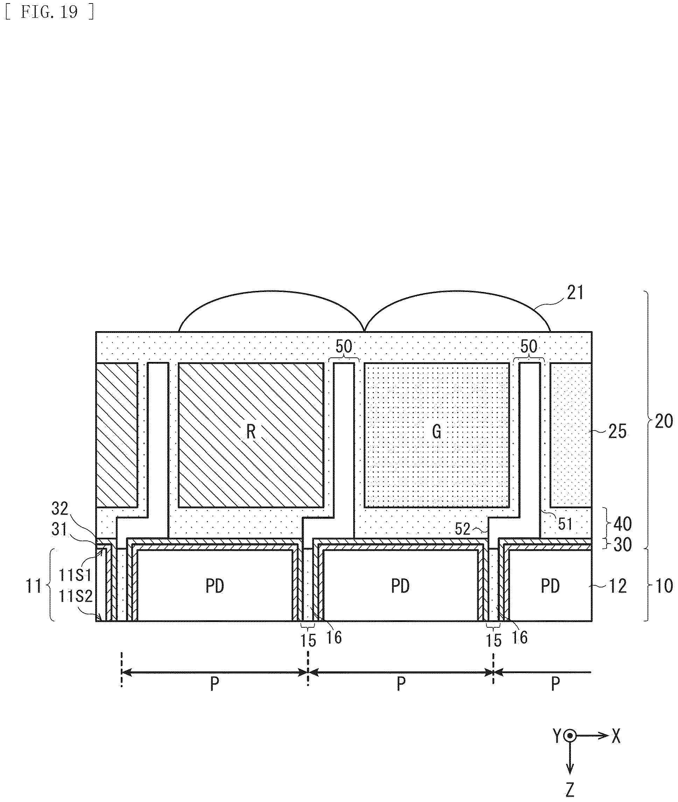

FIG. 19 is a diagram illustrating an example of the cross-sectional configuration of the imaging device according to a fifth modification example of the present disclosure. As in the example illustrated in FIG. 19, a portion of the structure 50 may be provided in the separation unit 15. In the example illustrated in FIG. 19, a portion of the second section 52, that is, the air gap of the structure 50 is formed in the separation unit 15. In a case of the present modification example, it is possible to obtain an effect similar to that in the above embodiment.

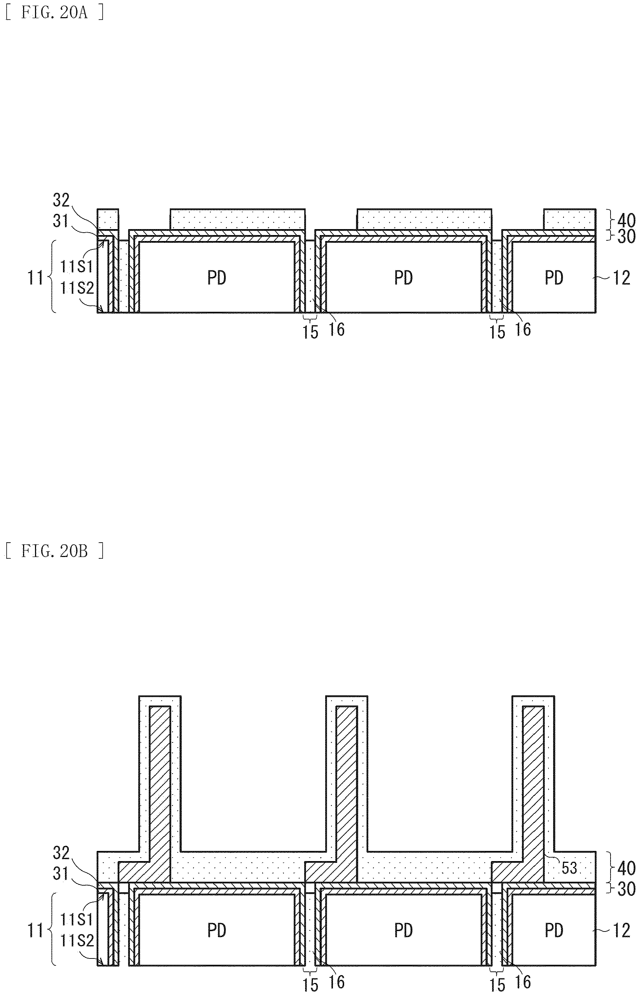

FIGs. 20A to 20D are diagrams illustrating an example of a method for manufacturing the imaging device according to the fifth modification example. First, as illustrated in FIG. 20A, on the semiconductor substrate 11, on which the elements such as the photoelectric conversion unit 12 are formed, the metal compound layer 30 is formed. Furthermore, as the oxide film layer 40, a silicon dioxide film is formed.

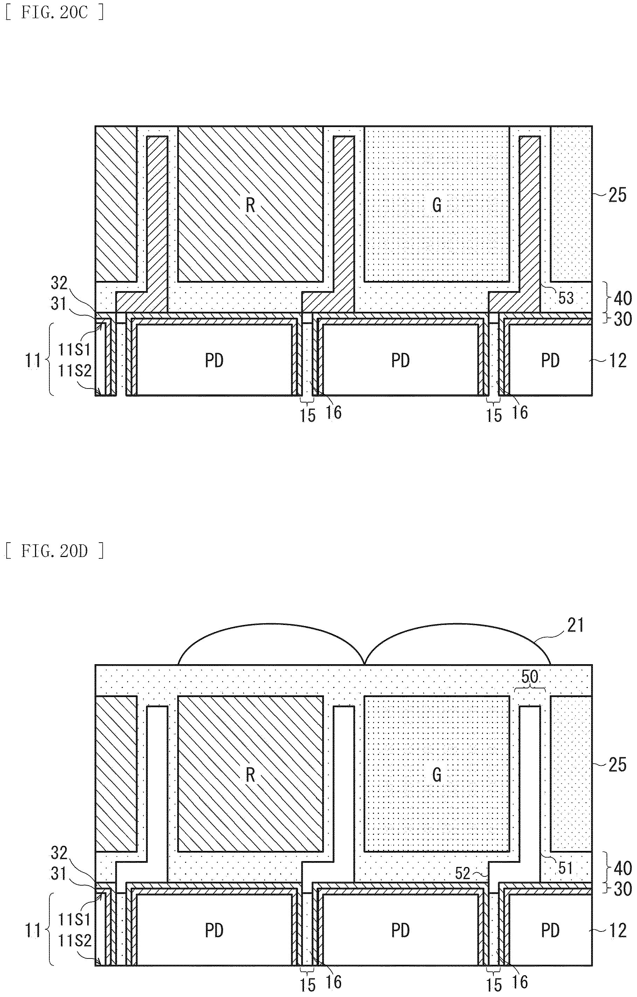

Next, as illustrated in FIG. 20B, the a-Si film 53 is formed by the CVD, and a silicon dioxide film is formed, as a protection film, around the a-Si film 53. Then, as illustrated in FIG. 20C, the color filter 25 is formed.

Next, a hole is formed in a portion of the silicon dioxide film on the a-Si film 53, and etching is performed on the a-Si film 53 via the hole. As a result, the air gap is provided, and the first section 51 and the second section 52 of the structure 50 are formed. By closing the hole by the silicon dioxide film after the air gap is formed, as illustrated in FIG. 20D, the structure 50 having the air gap is formed. According to the above manufacturing method, it is possible to manufacture the imaging device 1 illustrated in FIG. 19.

### (2-2. Sixth Modification Example)

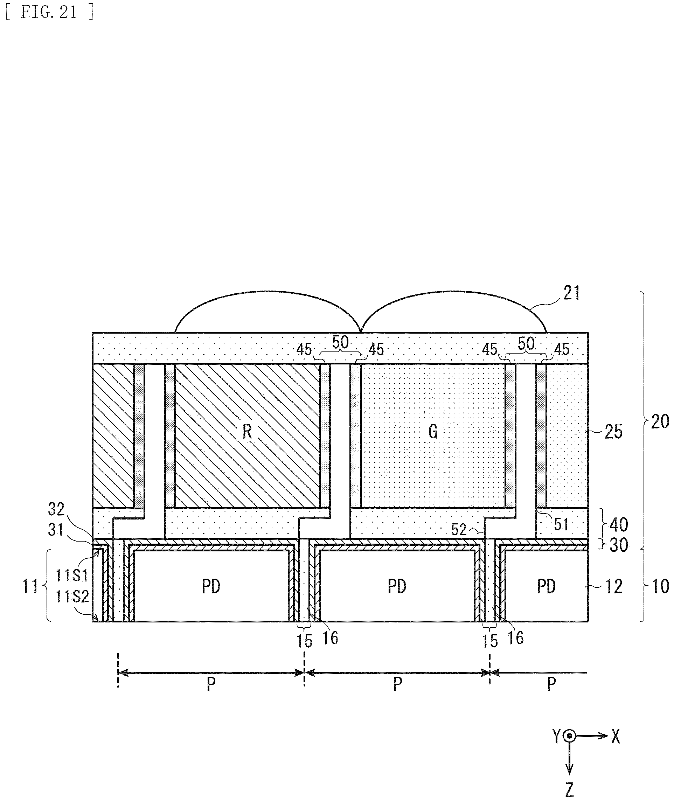

FIG. 21 is a diagram illustrating an example of the cross-sectional configuration of the imaging device according to a sixth modification example. As in the example illustrated in FIG. 21, the structure 50 of the imaging device 1 may include a protection film 45 provided between the color filter 25 and the air gap. In the example illustrated in FIG. 21, the protection film 45 is provided between the first section 51 and the color filter 25.

The protection film 45 includes an oxide film, a nitride film, or both. The protection film 45 may include a silicon dioxide film, a silicon nitride film, a silicon oxynitride film, a metal oxide film (for example, aluminum oxide or magnesium oxide), or the like.

### <3. Application Example>

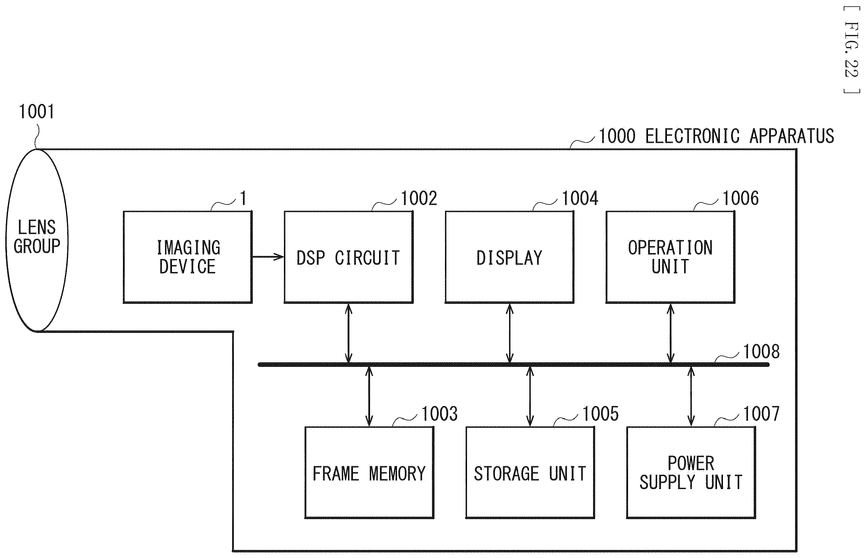

The imaging device 1 or the like is applicable to various types of electronic apparatuses having an imaging function, for example, a camera system such as a digital still camera or a video camera, a mobile phone having an imaging function, or the like. FIG. 22 illustrates a schematic configuration of an electronic apparatus 1000.

The electronic apparatus 1000 includes, for example, a lens group 1001, the imaging device 1, a Digital Signal Processor (DSP) circuit 1002, a frame memory 1003, a display 1004, a recording unit 1005, an operation unit 1006, and a power supply unit 1007, and these are coupled to each other via a bus line 1008.

The lens group 1001 takes in incident light (image light) from an object and forms an image on an imaging surface of the imaging device 1. The imaging device 1 converts a light amount of the incident light for forming the image on the imaging surface with the lens group 1001 into an electric signal in pixel units and supplies the electric signal to the DSP circuit 1002 as a pixel signal.

The DSP circuit 1002 is a signal processing circuit that processes the signal supplied from the imaging device 1. The DSP circuit 1002 outputs image data obtained by processing the signal from the imaging device 1. The frame memory 1003 temporality holds the image data processed by the DSP circuit 1002 in frame units.

The display 1004 includes a panel-type display device, for example, a liquid crystal panel, an organic Electro Luminescence (EL) panel, or the like and records image data of a moving image or a still image imaged by the imaging device 1 in a recording medium such as a semiconductor memory or a hard disk.

The operation unit 1006 outputs operation signals regarding various functions of the electronic apparatus 1000, in accordance with an operation by a user. The power supply unit 1007 appropriately supplies various power supplies to be operation power supplies of the DSP circuit 1002, the frame memory 1003, the display 1004, the recording unit 1005, and the operation unit 1006, to these supply targets.

### <4. Example of Application >

### (Example of Application to Movable Body)

A technique of the present disclosure (the present technique) is applicable to various products. For example, the technique of the present disclosure may be implemented as a device to be mounted on any type of movable bodies such as automobiles, electric automobiles, hybrid electric automobiles, motorcycles, bicycles, personal mobilities, airplanes, drones, vessels, or robots.

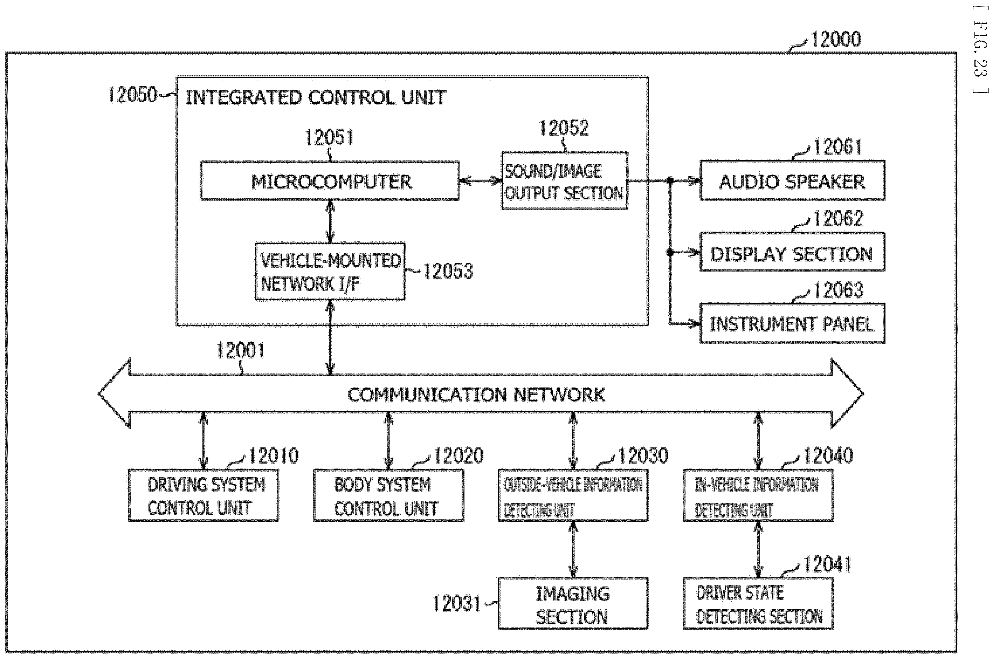

FIG. 23 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 23, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 23, an audio speaker 12061, a display section 12062, and an instrument panel 12063 are illustrated as the output device. The display section 12062 may, for example, include at least one of an on-board display and a head-up display.

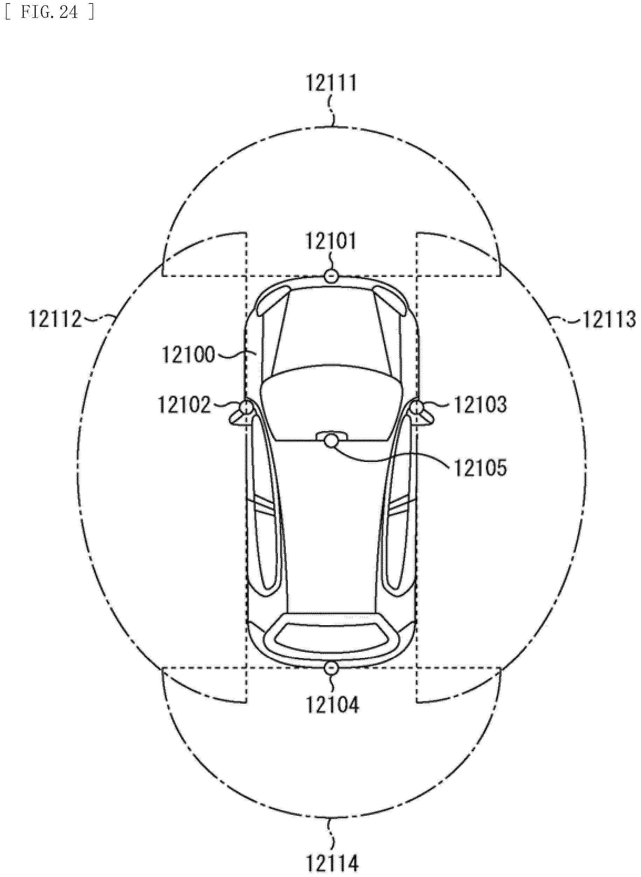

FIG. 24 is a diagram depicting an example of the installation position of the imaging section 12031.

In FIG. 24, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 24 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

As described above, an example of the movable body control system to which the technique of the present disclosure may be applied has been described. The technique of the present disclosure may be applied to, for example, the imaging section 12031, among the components described above. Specifically, for example, the imaging device 1 or the like is applicable to the imaging section 12031. By applying the technique of the present disclosure to the imaging section 12031, it is possible to obtain a high-definition captured image, and it is possible for the movable body control system to perform control with high accuracy using the captured image.

### (Example of Application to Endoscopic Surgery System)

The technique of the present disclosure (present technique) is applicable to various products. For example, the technique of the present disclosure may be applied to an endoscopic surgery system.

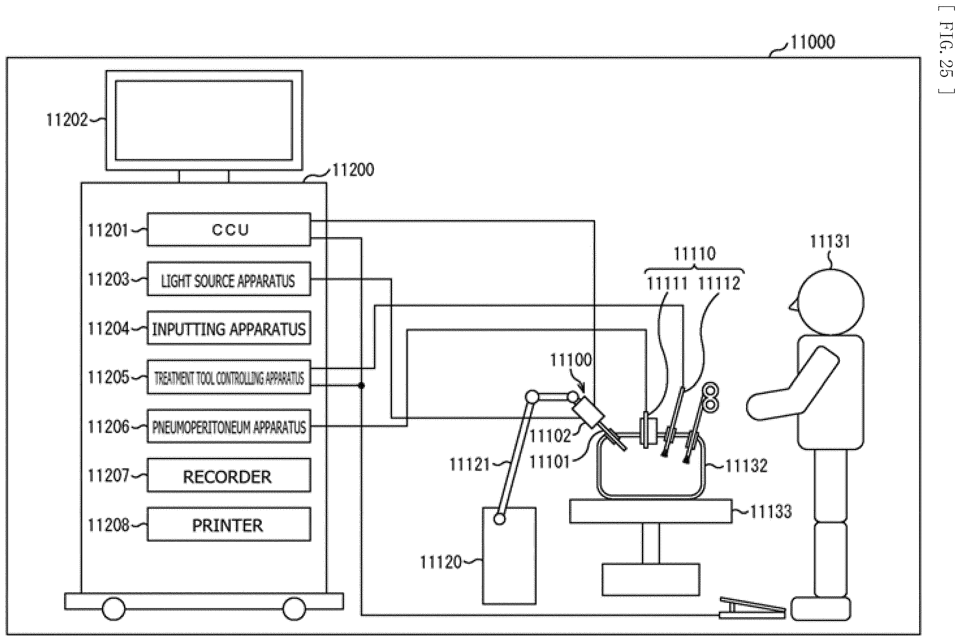

FIG. 25 is a view depicting an example of a schematic configuration of an endoscopic surgery system to which the technology according to an embodiment of the present disclosure (present technology) can be applied.

In FIG. 25, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

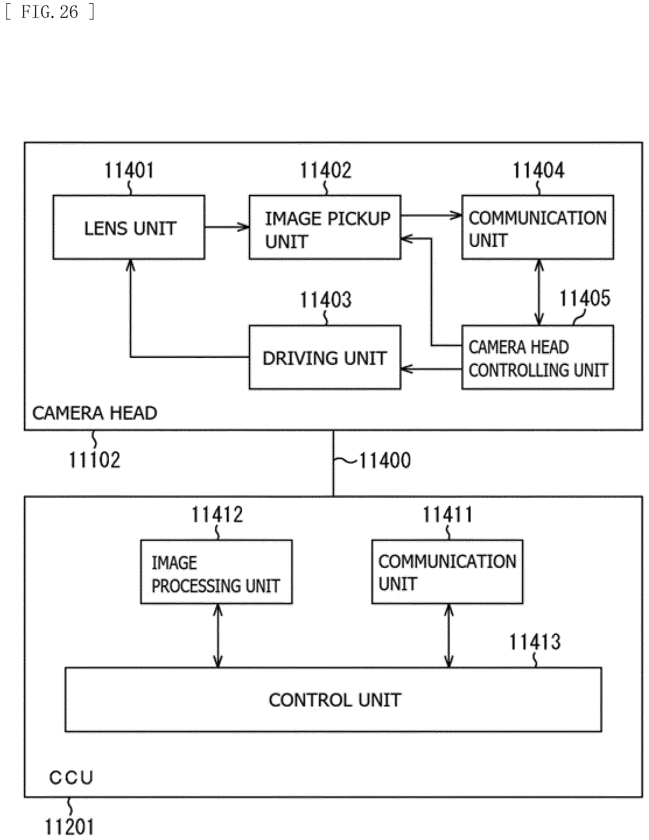

FIG. 26 is a block diagram depicting an example of a functional configuration of the camera head 11102 and the CCU 11201 depicted in FIG. 25.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

As described above, an example of the endoscopic surgery system to which the technique of the present disclosure may be applied has been described. The technique of the present disclosure may be preferably applied to, for example, the image pickup unit 11402 provided in the camera head 11102 of the endoscope 11100, among the components described above. As a result of applying the technique of the present disclosure to the image pickup unit 11402, it is possible to increase sensitivity of the image pickup unit 11402 and to provide the high-definition endoscope 11100.

Although the present disclosure has been described above using the embodiments, the modification examples, the application example, and the examples of the application, the present technique is not limited to the embodiments or the like, and it is possible to make various modifications. For example, although the modification examples described above have been described as the modification example of the embodiment, it is possible to appropriately combine the components of each modification example.

The imaging device according to the embodiment of the present disclosure includes the plurality of pixels including the photoelectric conversion unit that photoelectrically converts light, the color filter provided for each pixel, the separation unit provided between the adjacent photoelectric conversion units, the structure having the air gap provided between the adjacent color filters, and the metal compound layer provided on the photoelectric conversion unit between the color filter and the photoelectric conversion unit. The structure is provided from between the adjacent color filters to the metal compound layer and is coupled to the separation unit. Therefore, it is possible to prevent the occurrence of the color mixture.

Note that the effects described herein are examples and not limited, and may be other effects. Furthermore, the present disclosure may have the following configurations.
(1) An imaging device including:
   a plurality of pixels including a photoelectric conversion unit that photoelectrically converts light;
   a color filter provided for each of the pixels;
   a separation unit provided between the adjacent photoelectric conversion units;
   a structure having an air gap provided between the adjacent color filters; and
   a metal compound layer provided on the photoelectric conversion unit between the color filter and the photoelectric conversion unit, in which
   the structure is provided from between the adjacent color filters to the metal compound layer and is coupled to the separation unit.
(2) The imaging device according to (1), in which the metal compound layer comprises a layer including metal oxide or metal nitride.
(3) The imaging device according to (1) or (2), in which the structure has contact with the metal compound layer.
(4) The imaging device according to any one of (1) to (3), further including an oxide film layer provided between the color filter and the metal compound layer.
(5) The imaging device according to any one of (1) to (4), in which the structure extends to between the oxide film layer and the metal compound layer.
(6) The imaging device according to any one of (1) to (5), in which the metal compound layer includes a film having a fixed charge.
(7) The imaging device according to any one of (1) to (5), in which the metal compound layer includes a film having a fixed charge and an antireflection film.
(8) The imaging device according to (7), in which
   the film having the fixed charge is provided on the photoelectric conversion unit, and
   the antireflection film is provided on the film having the fixed charge.
(9) The imaging device according to any one of (1) to (8), in which
   the structure includes a first section provided between the adjacent color filters and a second section provided to the separation unit along the metal compound layer,
   the first section has an air gap, and
   the second section includes a metal film.
(10) The imaging device according to (9), in which the second section includes a first metal film provided on the metal compound layer and a second metal film provided on the first metal film.
(11) The imaging device according to (9) or (10), further including:
   an oxide film layer provided between the color filter and the metal compound layer, in which
   a portion of the first section is provided in the oxide film layer.
(12) The imaging device according to any one of (9) to (11), in which a portion of the second section is provided in the separation unit.
(13) The imaging device according to any one of (9) to (12), further including:
   a light receiving unit in which the plurality of pixels is provided, in which
   the structure includes the second section having a size that differs depending on a distance from a center of the light receiving unit.
(14) The imaging device according to any one of (1) to (8), in which
   the structure includes a first section provided between the adjacent color filters and a second section provided to the separation unit along the metal compound layer, and
   the first section and the second section have an air gap.
(15) The imaging device according to (14), in which a portion of the second section is provided in the separation unit.
(16) The imaging device according to (14) or (15), in which the structure includes a protection film provided between the color filter and the air gap.
(17) The imaging device according to (16), in which the protection film includes an oxide film, a nitride film, or both.
(18) The imaging device according to any one of (14) to (17), further including:
   a light receiving unit in which the plurality of pixels is provided, in which
   the structure includes the second section having a size that differs depending on a distance from a center of the light receiving unit.
(19) The imaging device according to any one of (1) to (18) in which the structure is provided around the color filter.
(20) The imaging device according to any one of (1) to (19), in which the separation unit includes a trench provided around the photoelectric conversion unit.

The present application claims the benefit of Japanese Priority Patent Application JP2022-123953 filed with the Japan Patent Office on August 3, 2022, the entire contents of which are incorporated herein by reference.

It should be understood by those skilled in the art that various modifications, combinations, subcombinations and alterations may occur depending on design requirements and other factors insofar as they are within the scope of the appended claims or the equivalents thereof.

## Claims

1. An imaging device comprising:
a plurality of pixels including a photoelectric conversion unit that photoelectrically converts light;
a color filter provided for each of the pixels;
a separation unit provided between the adjacent photoelectric conversion units;
a structure having an air gap provided between the adjacent color filters; and
a metal compound layer provided on the photoelectric conversion unit between the color filter and the photoelectric conversion unit, wherein
the structure is provided from between the adjacent color filters to the metal compound layer and is coupled to the separation unit.

2. The imaging device according to claim 1, wherein the metal compound layer comprises a layer including metal oxide or metal nitride.

3. The imaging device according to claim 1, wherein the structure has contact with the metal compound layer.

4. The imaging device according to claim 1, further comprising an oxide film layer provided between the color filter and the metal compound layer.

5. The imaging device according to claim 4, wherein the structure extends to between the oxide film layer and the metal compound layer.

6. The imaging device according to claim 1, wherein the metal compound layer includes a film having a fixed charge.

7. The imaging device according to claim 1, wherein the metal compound layer includes a film having a fixed charge and an antireflection film.

8. The imaging device according to claim 7, wherein
the film having the fixed charge is provided on the photoelectric conversion unit, and
the antireflection film is provided on the film having the fixed charge.

9. The imaging device according to claim 1, wherein
the structure includes a first section provided between the adjacent color filters and a second section provided to the separation unit along the metal compound layer,
the first section has an air gap, and
the second section includes a metal film.

10. The imaging device according to claim 9, wherein the second section includes a first metal film provided on the metal compound layer and a second metal film provided on the first metal film.

11. The imaging device according to claim 9, further comprising:
an oxide film layer provided between the color filter and the metal compound layer, wherein
a portion of the first section is provided in the oxide film layer.

12. The imaging device according to claim 9, wherein a portion of the second section is provided in the separation unit.

13. The imaging device according to claim 9, further comprising:
a light receiving unit in which the plurality of pixels is provided, wherein
the structure includes the second section having a size that differs depending on a distance from a center of the light receiving unit.

14. The imaging device according to claim 1, wherein
the structure includes a first section provided between the adjacent color filters and a second section provided to the separation unit along the metal compound layer, and
the first section and the second section have an air gap.

15. The imaging device according to claim 14, wherein a portion of the second section is provided in the separation unit.

16. The imaging device according to claim 14, wherein the structure includes a protection film provided between the color filter and the air gap.

17. The imaging device according to claim 16, wherein the protection film includes an oxide film, a nitride film, or both.

18. The imaging device according to claim 14, further comprising:
a light receiving unit in which the plurality of pixels is provided, wherein
the structure includes the second section having a size that differs depending on a distance from a center of the light receiving unit.

19. The imaging device according to claim 1, wherein the structure is provided around the color filter.

20. The imaging device according to claim 1, wherein the separation unit includes a trench provided around the photoelectric conversion unit.
